# EUROPEAN PATENT APPLICATION

(11) **EP 4 156 227 A1**
(43) Date of publication of application: **29.03.2023**
(21) Application number: 21199203.7
(22) Date of filing: 27.09.2021
(51) Int. Cl.: H01J 37/04

(54) **CHARGED PARTICLE APPARATUS AND METHOD**

(71) Applicant: ASML Netherlands B.V., 5500 AH Veldhoven (NL)
(72) Inventor: OSTERBERG, Mans, Johan, Bertil, 5500 AH Veldhoven (NL); SCHUURBIERS, Koen, 5500 AH Veldhoven (NL)
(74) Representative: ASML Netherlands B.V.

(57) **Abstract**

A charged particle apparatus configured to project a multi-beam of charged particles along a multi-beam path toward a sample, the charged particle apparatus comprising: a charged particle source configured to emit a charged particle beam toward a sample; a charged particle-optical device configured to project sub-beams of a multi-beam of charged particles along the multi-beam path toward the sample, the sub-beams of the multi-beam of charged particles derived from the charged particle beam; a tube surrounding the multi-beam path configured to operate at a first potential difference from a ground potential; and a support configured to support the sample at a second potential difference from the ground potential, the first potential difference and the second potential difference having a difference so as to accelerate the multi-beam of charged particles towards the sample; wherein the first potential difference is greater than the second potential difference.

## Description

### FIELD

The embodiments provided herein generally relate to charged particle apparatuses and methods for projecting a multi-beam of charged particles toward a sample.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample. The intensity of the electron beams comprising the backscattered electrons and the secondary electrons may vary based on the properties of the internal and external structures of the sample, and thereby may indicate whether the sample has defects.

The relatively high energy beam of electrons may be emitted from a source cathode. The final deceleration step may be achieved by biasing the sample to a high voltage close to that of the source cathode. The sample holder may be maintained at high voltage so as to bias the sample. This can make the design of any moving stage complicated. There is also a risk of damage to the sample and components of the tool through electric discharge, for which the risk may be greater between relatively moving components such as the holder and a stage which moves the sample and the holder.

### SUMMARY

It is an object of the present disclosure to provide embodiments that support beams of charged particles landing on a sample at low landing energy while reducing the complexity of any moving stage and reducing the risk of damaging the sample.

According to a first aspect of the invention, there is provided a charged particle apparatus configured to project a multi-beam of charged particle along a multi-beam path toward a sample, the charged particle apparatus comprising: a charged particle source configured to emit a charged particle beam toward a sample; a charged particle-optical device configured to project sub-beams of a multi-beam of charged particles along the multi-beam path toward the sample, the sub-beams of the multi-beam of charged particles derived from the charged particle beam; a tube surrounding the multi-beam path configured to operate at a first potential difference from a ground potential; and a support configured to support the sample at a second potential difference from the ground potential, the first potential difference and the second potential difference having a difference so as to accelerate the multi-beam of charged particles towards the sample; wherein the first potential difference is greater than the second potential difference.

According to a second aspect of the invention, there is provided a method for projecting a multi-beam of charged particles toward a sample, the method comprising: emitting a charged particle beam; projecting along a multi-beam path toward a sample sub-beams of a multi-beam of charged particles derived from the charged particle beam using a charged particle-optical device; accelerating the charged particle beam toward the sample using a tube surrounding the multi-beam path, wherein the tube operates at a first potential difference from a ground potential; and holding the sample at a second potential difference from the ground potential; wherein the first potential difference is greater than the second potential difference.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary electron beam inspection apparatus.
**FIG. 2** is a schematic diagram illustrating an exemplary electron multi-beam apparatus that is part of the exemplary electron beam inspection apparatus of **FIG. 1****.**
**FIG. 3** is a schematic diagram of an exemplary multi-beam electron apparatus.
**FIG. 4** is a schematic diagram of an exemplary electron apparatus comprising a macro collimator and macro scan deflector.
**FIG. 5** is a schematic diagram of an exemplary multi-beam electron apparatus according to an embodiment.
**FIG. 6** is a schematic diagram of part of the multi-beam electron apparatus of **FIG. 5****.**
**FIG. 7** is a schematic cross-sectional view of an objective lens array of an electron apparatus according to an embodiment.
**FIG. 8** is a schematic cross-sectional view of a control lens array and an objective lens array of an electron apparatus according to an embodiment.
**FIG. 9** is a bottom view of a modification of the objective lens array of **FIG. 7** or **FIG. 8****.**
**FIG. 10** is an enlarged schematic cross-sectional view of a detector incorporated in the objective lens array of **FIG. 7** or **FIG. 8****.**
**FIG. 11** is a bottom view of a detector element of a detector.
**FIG. 12** is a schematic diagram of the exemplary electron apparatus according to an embodiment.
**FIG. 13** is a schematic diagram of the exemplary electron apparatus according to an embodiment.
**FIG. 14** is a schematic diagram of the exemplary electron apparatus according to an embodiment.
**FIG. 15** is a schematic diagram of the exemplary electron apparatus according to an embodiment.
**FIG. 16** is a schematic diagram of the exemplary electron apparatus according to an embodiment.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%,. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate signal electrons such as secondary electrons. The detection apparatus captures the signal electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

Within the following description of drawings the same or like reference numbers refer to the same or like components or entities, and only the differences with respect to the individual embodiments are described. While the description and drawings are directed to an electron-optical system, it is appreciated that the embodiments are not used to limit the present disclosure to specific charged particles. References to electrons throughout the present document may therefore be more generally considered to be references to charged particles, with the charged particles not necessarily being electrons. For example, reference to an electron apparatus may be more generally considered to be reference to a charged particle apparatus.

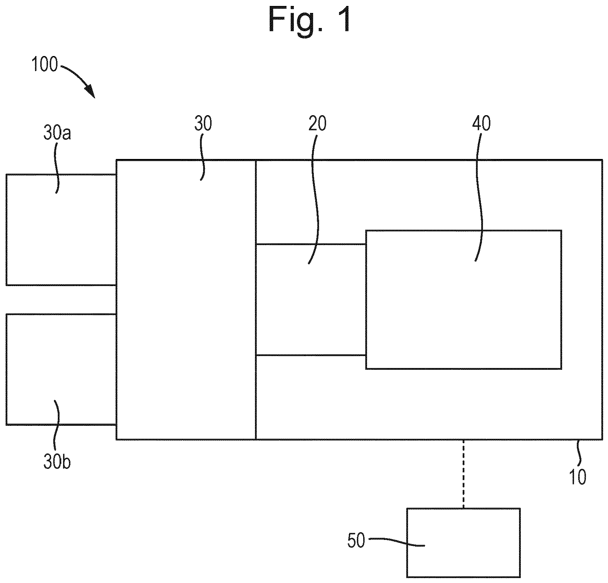

Reference is now made to **FIG. 1****,** which is a schematic diagram illustrating an exemplary electron beam inspection apparatus 100. The electron beam inspection apparatus 100 of **FIG. 1** includes a main chamber 10, a load lock chamber 20, an electron apparatus 40 (which may also be called an electron assessment apparatus or an electron beam system or tool), an equipment front end module (EFEM) 30 and a controller 50. The electron apparatus 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron apparatus 40 by which it may be inspected. The electron apparatus 40 comprises an electron-optical device 41. The electron-optical device 41 may be an electron-optical column configured to project at least one electron beam towards the sample 208, and/or an objective lens module configured to focus at least one electron beam onto the sample 208. The electron-optical device may also comprise a detector module configured to detect electrons emitted from the sample 208, and/or a control lens module configured to adjust an electron-optical parameter of at least one electron beam. In an embodiment the electron-optical column may comprise the objective lens module and the detector module and optionally the control lens module. In an embodiment the electron-optical device comprises an objective lens assembly which may be comprised in the electron-optical column. The objective lens assembly comprises an objective lens array associated with (e.g. integrated with) one or more other electron-optical components such as a detector array and optionally a control lens array. The electron-optical device 41 may be a multi-beam electron-optical device 41 for a multi-beam projected towards the sample 208.

The controller 50 is electronically connected to electron-optical components of the electron-optical device 41 of the electron apparatus 40. The controller 50 may be a processor (such as a computer) configured to control the electron beam inspection apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the electron beam inspection apparatus 100 or it can be distributed over at least two of the component elements. The controller may be considered to be part of the electron-optical device 41. While the present disclosure provides examples of the main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

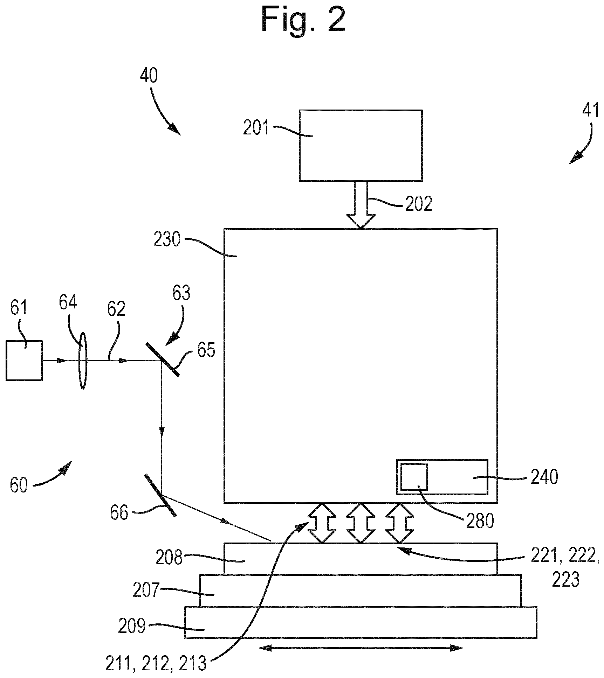

Reference is now made to **FIG. 2****,** which is a schematic diagram illustrating an exemplary electron apparatus 40 including a multi-beam electron-optical device 41 that is part of the exemplary electron beam inspection apparatus 100 of **FIG. 1****.** The electron apparatus 40 comprises an electron source 201 and a projection apparatus 230. The electron apparatus 40 further comprises a motorized stage 209 and a support 207 (which may also be referred to as a sample holder). The projection apparatus 230 may be referred to as the electron-optical device 41. The support 207 is supported by motorized stage 209 so as to hold a sample 208 (e.g., a substrate or a mask) for inspection. The electron-optical device 41 may further comprise a detector 240 (e.g. an electron detection device).

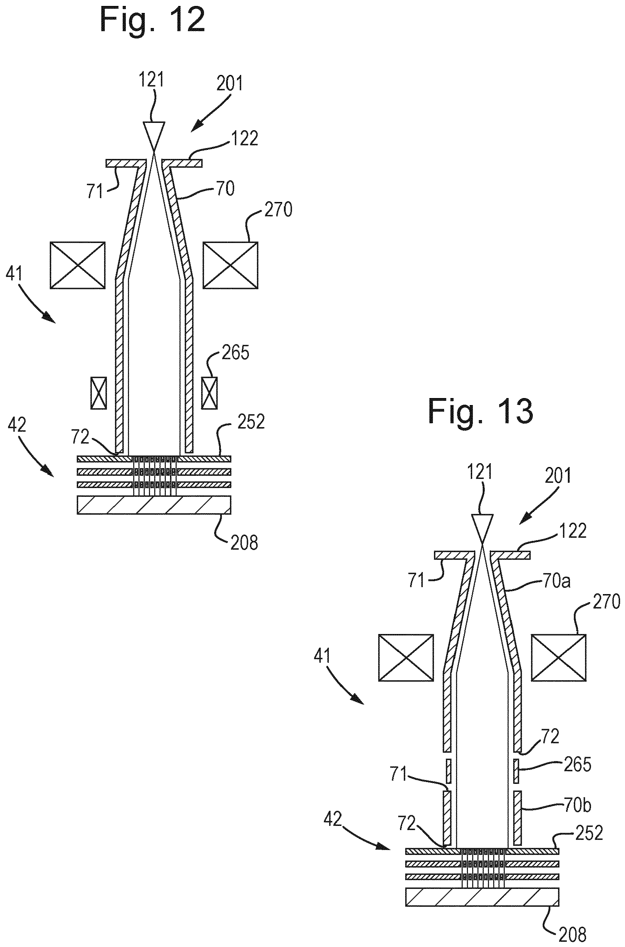

The electron source 201 may comprise a cathode 121 (not shown in **FIG. 2** but shown in **FIGs. 12-16**) and an extractor or anode 122 (not shown in **FIG. 2** but shown in **FIGs. 12-16**). During operation, the electron source 201 is configured to emit electrons as primary electrons from the cathode 121. The primary electrons are extracted or accelerated by the extractor and/or the anode 122 to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the electron beam inspection apparatus 100 of **FIG. 1****,** such as the electron source 201, the detector 240, the projection apparatus 230, and the motorized stage 209. The controller 50 may perform various image and signal processing functions. The controller 50 may also generate various control signals to govern operations of the electron beam inspection apparatus 100, including the multi-beam electron apparatus 40.

The projection apparatus 230 may be configured to focus sub-beams 211, 212, and 213 onto a sample 208 for inspection and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons, i.e. examples of signal electrons. The secondary electrons typically have electron energy ≤ 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the multi-beam electron apparatus 40 such as the detector 240 (as shown in **FIG. 2**). However, the signal processing system 280 may be incorporated into any components of the electron beam inspection apparatus 100 or multi-beam electron apparatus 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected signal particles. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

The controller 50 may control the motorized stage 209 to move sample 208 during inspection of the sample 208. The controller 50 may enable the motorized stage 209 to move the sample 208 in a direction, preferably continuously, for example at a constant speed, at least during sample inspection. The controller 50 may control movement of the motorized stage 209 so that it changes the speed of the movement of the sample 208 dependent on various parameters. For example, the controller 50 may control the stage speed (including its direction) depending on the characteristics of the inspection steps of scanning process.

Known multi-beam systems, such as the electron apparatus 40 and electron beam inspection apparatus 100 described above, are disclosed in US2020118784, US20200203116, US 2019/0259570 and US2019/0259564 which are hereby incorporated by reference.

As shown in **FIG. 2****,** in an embodiment the electron apparatus 40 comprises a projection assembly 60. The projection assembly 60 is arranged to direct a light beam 62 such that the light beam 62 enters between the electron-optical device 41 and the sample 208. The projection assembly 60 may be employed to illuminate the light beam 62 on the sample 208, so as to control the accumulated charges due to effects such as photoconductivity, photoelectric, or thermal effects. In an embodiment the projection system 60 comprises a light source 61. The light source 61 is configured to emit the light beam 62. In an embodiment the light source 61 is a laser light source. In an embodiment the projection assembly 60 comprises an optical system 63 configured to focus the light beam 62 to be narrower in a direction perpendicular to the surface of the sample 208 than in a direction parallel to the surface. In an embodiment the optical system 63 comprises a cylindrical lens 64 configured to focus the light beam 62 more in one direction than in an orthogonal direction. In an embodiment the optical system 63 comprises reflecting surfaces 65, 66 such as mirrors. For example two reflecting surfaces 65, 66 may be provided.

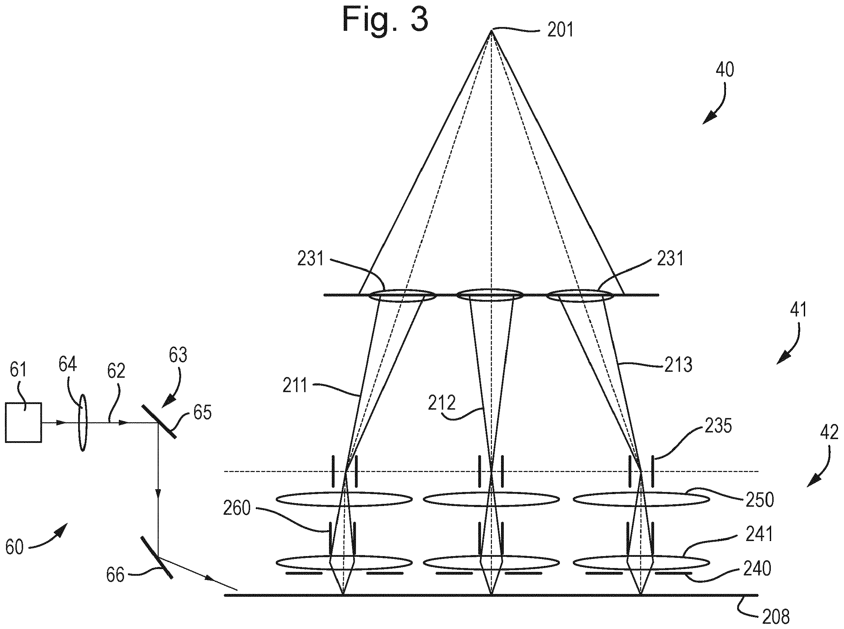

Components of an electron apparatus 40 which may be used in the present invention are described below in relation to **FIG. 3** which is a schematic diagram of an electron apparatus 40. The electron apparatus 40 of **FIG. 3** may correspond to the electron apparatus 40 (which may also be referred to as a system or a tool) mentioned above or later herein.

The electron source 201 directs electrons toward an array of condenser lenses 231 (otherwise referred to as a condenser lens array). The electron source 201 is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an electron beam, for example from the source, into a plurality of sub-beams, with the array providing a lens for each sub-beam. Each condenser lens in the condenser lens array may be for operating on a sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

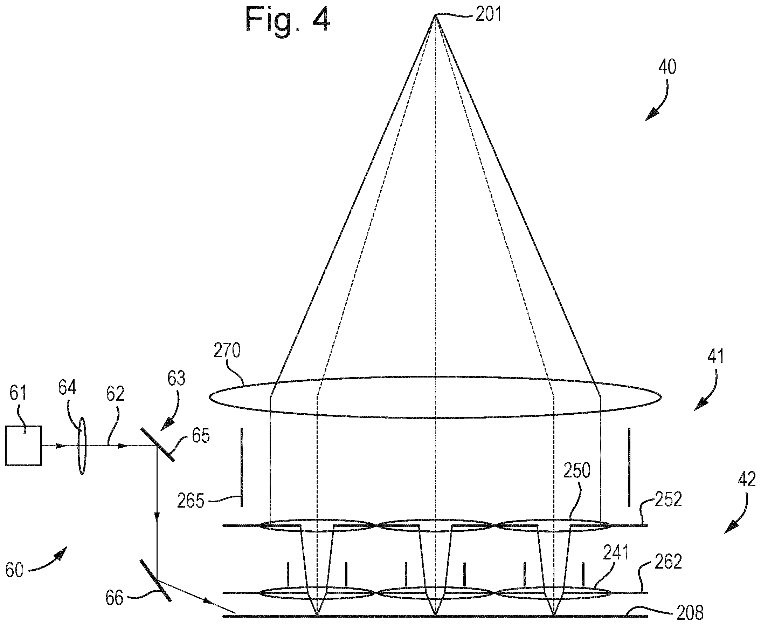

Each condenser lens 231 in the array directs electrons into a respective sub-beam 211, 212, 213 which is focused at a respective intermediate focus down beam of the condenser lens array. The sub-beams diverge with respect to each other. In an embodiment, deflectors 235 are provided at the intermediate focuses. The deflectors 235 are positioned in the sub-beam paths at, or at least around, the position of the corresponding intermediate points of focus. The deflectors 235 are positioned in or close to the sub-beam paths at the intermediate image plane of the associated sub-beam. The deflectors 235 are configured to operate on the respective sub-beams 211, 212, 213. The deflectors 235 are configured to bend a respective sub-beam 211, 212, 213 by an amount effective to ensure that the principal ray (which may also be referred to as the beam axis) is incident on the sample 208 substantially normally (i.e. at substantially 90° to the nominal surface of the sample). The deflectors 235 may be referred to as collimators or collimator deflectors. The deflectors 235 in effect collimate the paths of the sub-beams so that before the deflectors, the sub-beam paths with respect to each other are diverging. Down beam of the deflectors the sub-beam paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array. The collimator may comprise a macro collimator 270 (e.g. as shown in **FIG. 4**), instead of, or in addition to the deflectors 235. Thus, the macro collimator 270 described below in relation to **FIG. 4** may be provided with the features of **FIG. 3****.** This is generally less preferred than providing the collimator array as deflectors 235.

Below (i.e. down beam or further from electron source 201) the deflectors 235 there is a control lens array 250. The sub-beams 211, 212, 213 having passed through the deflectors 235 are substantially parallel on entry to the control lens array 250. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations.

In further detail, it is desirable to use the control lens array 250 to determine the landing energy. However, it is possible to use in addition the objective lens array 241 to control the landing energy. In such a case, a potential difference over the objective lens is changed when a different landing energy is selected. One example of a situation where it is desirable to partly change the landing energy by changing the potential difference over the objective lens is to prevent the focus of the sub-beams getting too close to the objective lenses. In such a situation there is a risk of components of the objective lens array 241 having to be too thin to be manufacturable. The same may be said about a detector at this location. This situation can for example occur in case the landing energy is lowered. This is because the focal length of the objective lens roughly scales with the landing energy used. By lowering the potential difference over the objective lens, and thereby lowering the electric field inside the objective lens, the focal length of the objective lens is made larger again, resulting in a focus position further below the objective lens. Note that use of just an objective lens would limit control of magnification. Such an arrangement could not control demagnification and/or opening angle. Further, using the objective lens to control the landing energy could mean that the objective lens would be operating away from its optimal field strength. That is unless mechanical parameters of the objective lens (such as the spacing between its electrodes) could be adjusted, for example by exchanging the objective lens.

The control lens array 250 comprises a plurality of control lenses. Each control lens comprises at least one electrode, preferably two electrodes (e.g. two or three electrodes) connected to respective potential sources. The control lens array 250 may comprise one or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). Each control lens may be associated with a respective objective lens. The control lens array 250 is positioned up-beam of the objective lens array 241.

The control lens array 250 may be considered as one or more electrodes additional to the electrodes of the objective lens array 241. The control lens array 250 provides extra degrees of freedom for controlling the sub-beams. A greater number of electrodes comprised in the control lens array 250 provides a greater number of degrees of freedom. For example, these extra electrodes may permit landing energy and/or magnification control independent of the field strength of the objective lens array 241. In some designs the control lens may thus be part of the objective lens. Reference to such electrodes may thus be as part of the objective lens rather than a separate lens such as a control lens. Reference to a control lens in such an arrangement may be reference to functionally equivalent electrodes of the objective lens.

The control lens array 250 comprises a control lens for each sub-beam 211, 212, 213. A function of the control lens array 250 is to optimize the beam opening angle with respect to the demagnification of the beam and/or to control the beam energy delivered to the objective lens array 241 which directs the sub-beams 211, 212, 213 onto the sample 208. The opening angle (or demagnification) and beam energy delivered by the control lens to the objective lens may be considered two degrees of freedom of the sub-beams which the control lens may be used to control. The objective lens array 241 may be positioned at or near the base of the electron-optical system 41. The control lens array 250 is optional, but is preferred for optimizing a sub-beam up-beam of the objective lens array 241.

For ease of illustration, lens arrays are depicted schematically herein by arrays of oval shapes (as shown in **FIG. 3**). Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. Lens arrays may instead comprise multiple plates with apertures.

Optionally, an array of scan deflectors 260 is provided between the control lens array 250 and the array of objective lenses 234. The array of scan deflectors 260 comprises a scan deflector for each sub-beam 211, 212, 213. Each scan deflector is configured to deflect a respective sub-beam 211, 212, 213 in one or two directions so as to scan the sub beam across the sample 208 in one or two directions.

**FIG. 4** is a schematic diagram of an exemplary electron apparatus 40 comprising a macro collimator 270 and macro scan deflector 265. The electron source 201 directs electrodes toward a macro collimator 270. The electron source 201 is desirably a high brightness thermal field emitter with a good compromise between brightness and total emission current.

Sub-beams may be derived from the beam, for example, using a sub-beam forming array 252 (also known as a beam limiting aperture array) defining an array of beam-limiting apertures. The beam may separate into the sub-beams on meeting the control lens array 250, described below. The sub-beams are substantially parallel on entry to the control lens array 250.

The macro collimator 270 acts on the beam from the source 201 before the beam has been split into a multi-beam. The macro collimator 270 bends respective portions of the beam by an amount effective to ensure that a beam axis of each of the sub-beams derived from the beam is incident on the sample 208 substantially normally (i.e. at substantially 90° to the nominal surface of the sample 208). Thus the path of each sub-beam is at least intended to be orthogonal to the surface of the sample 208. The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g. a plurality of electromagnets forming a multi-pole arrangement). Alternatively or additionally, the macro collimator may be at least partially implemented electrostatically. The macro collimator may comprise an electrostatic lens or electrostatic lens arrangement comprising a plurality of electrostatic lens sub-units. The macro collimator 270 may use a combination of magnetic and electrostatic lenses.

In another arrangement (not shown), the macro collimator 270 may be partially or wholly replaced by a collimator element array provided down-beam of the sub-beam forming array. Each collimator element collimates a respective sub-beam. The collimator element array may be formed using MEMS manufacturing techniques so as to be spatially compact. The collimator element array may be the first deflecting or focusing electron-optical array element in the beam path down-beam of the source 201. The collimator element array may be up beam of the control lens array 250. The collimator element array may be in the same module as the control lens array 250.

As shown in **FIG. 4****,** in an embodiment the electron-optical device 41 comprises an objective lens array 241. The objective lens array 241 comprises a plurality of objective lenses. The objective lens array 241 may be an exchangeable module. The exchangeable module may feature other electron-optical elements such as a detector array and/or a control lens array.

Below (i.e. down beam or further from the electron source 201) the macro collimator 270 there is a control lens array 250. The control lens array 250 is configured to apply a focusing action to the sub-beams prior to the sub-beams reaching the objective lens array. The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations. Additionally or alternatively, the control lenses in the control lens array 250 are configured to control the opening angle of the sub-beams and/or to control demagnification (i.e. magnification) of the sub-beams and/or to control landing energy.

The control lens array 250 may be as described above in relation to **FIG. 3****.**

In the embodiment of **FIG. 4** a macro scan deflector 265 is provided to cause sub-beams to be scanned over the sample 208. The different sub-beams correspond to different portions of the beam across the multi-beam path, up-beam of the generation of the sub-beams. The macro scan deflector 265 deflects respective portions of the beam. The deflection of the portions of the beam causes the sub-beams corresponding to the respective portions to be scanned over the sample 208. In an embodiment, the macro scan deflector 265 comprises a macroscopic multi-pole deflector, for example with eight poles or more. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250.

In another arrangement (not shown), the macro scan deflector 265 may be partially or wholly replaced by a scan deflector array. The scan deflector array comprises a plurality of scan deflectors. The scan deflector array may be formed using MEMS manufacturing techniques. Each scan deflector scans a respective sub-beam over the sample 208. The scan-deflector array may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). The scan deflector array may be up beam of an objective lens array 241. The scan deflector array may be down beam of a control lens array 250. Although reference is made to a single sub-beam associated with a scan deflector, groups of sub-beams may be associated with a scan deflector. In an embodiment, the scanning deflectors described in EP2425444, which document is hereby incorporated by reference in its entirety specifically in relation to scan deflectors, may be used to implement the scan-deflector array. A scan-deflector array (e.g. formed using MEMS manufacturing techniques as mentioned above) may be more spatially compact than a macro scan deflector. The scan deflector array may be in the same module as the objective lens array 241.

In other embodiments both a macro scan deflector 265 and the scan-deflector array are provided. In such an arrangement, the scanning of the sub-beams over the sample surface may be achieved by controlling the macro scan deflector and the scan-deflector array together, preferably in synchronization.

In some embodiments, the electron-optical device 41 further comprises a sub-beam forming array 252. The sub-beam forming array 252 defines an array of beam-limiting apertures. The sub-beam forming array 252 may be referred to as an upper beam-limiting aperture array or up-beam beam-limiting aperture array. The sub-beam forming array 252 may comprise a plate (which may be a plate-like body) having a plurality of apertures. The sub-beam forming array 252 forms sub-beams from a beam of electrons emitted by the source 201. Portions of the beam other than those contributing to forming the sub-beams may be blocked (e.g. absorbed) by the sub-beam forming array 252 so as not to interfere with the sub-beams down-beam. The sub-beam forming array 252 may be referred to as a sub-beam defining aperture array or an upper beam limiter. The apertures of the sub-beam forming array 252 may have a diameter of at least 10 µm, optionally at least 20 µm, optionally at least 50 µm, optionally at least 100 µm, and optionally 120 µm. The apertures have a pitch that may by equal to that of the apertures of the beam apertures 406.

In some embodiments, as exemplified in **FIG. 4****,** the electron-optical device 41 is an objective lens array assembly (which is a unit that comprises the objective lens array 241) and comprises a beam shaping aperture array 262. The beam shaping aperture array 262 defines an array of beam-limiting apertures. The beam shaping aperture array 262 may be referred to as a lower beam limiter, lower beam-limiting aperture array or final beam-limiting aperture array. The beam shaping aperture array 262 may shape beams defined by an upper beam limiter 252. The use of two shaping aperture arrays is beneficial in situations in which use of just the upper beam limiter 252 risk introducing aberrations into the beams. The beam shaping aperture array 262 is closer to the sample 208. The use of the beam shaping aperture array 262 beneficially helps to reduce if not remove such aberrations. The performance of such beam shaping aperture array 262 may improve with proximity to the sample 208. The beam shaping aperture array 262 may comprise a plate (which may be a plate-like body) having a plurality of apertures. The beam shaping aperture array 262 may be down-beam from at least one electrode (optionally from all electrodes) of the control lens array 250. In some embodiments, the beam shaping aperture array 262 is down-beam from at least one electrode (optionally from all electrodes) of the objective lens array 241.

In an arrangement, the beam shaping aperture array 262 is structurally integrated with an electrode of the objective lens array 241. Desirably, the beam shaping aperture array 262 is positioned in a region of low electrostatic field strength. Each of the beam-limiting apertures is aligned with a corresponding objective lens in the objective lens array 241. The alignment is such that a portion of a sub-beam from the corresponding objective lens can pass through the beam-limiting aperture and impinge onto the sample 208. Each beam-limiting aperture has a beam limiting effect, allowing only a selected portion of the sub-beam incident onto the beam shaping aperture array 262 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

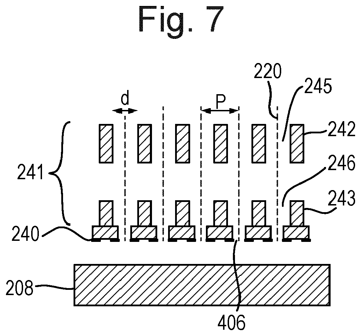

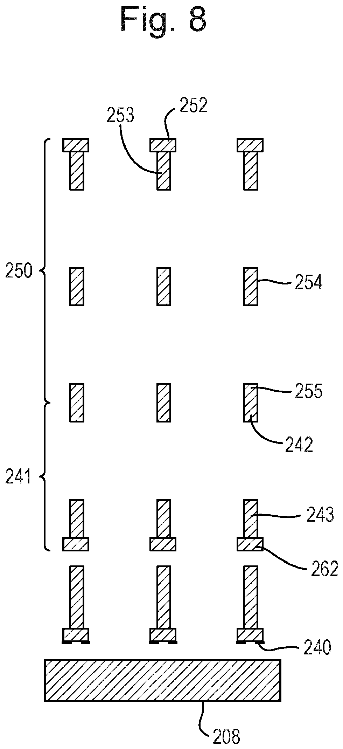

Any of the electron apparatuses 40 described herein may further comprise a detector 240. The detector 240 detects electrons emitted from the sample 208. The detected electrons may include any of the electrons detected by an SEM, including secondary and/or backscattered electrons emitted from the sample 208, which may be types of signal electron. An exemplary construction of a detector 240 is shown in **FIG. 7** and described in more detail below with reference to **FIGS. 8-10****.**

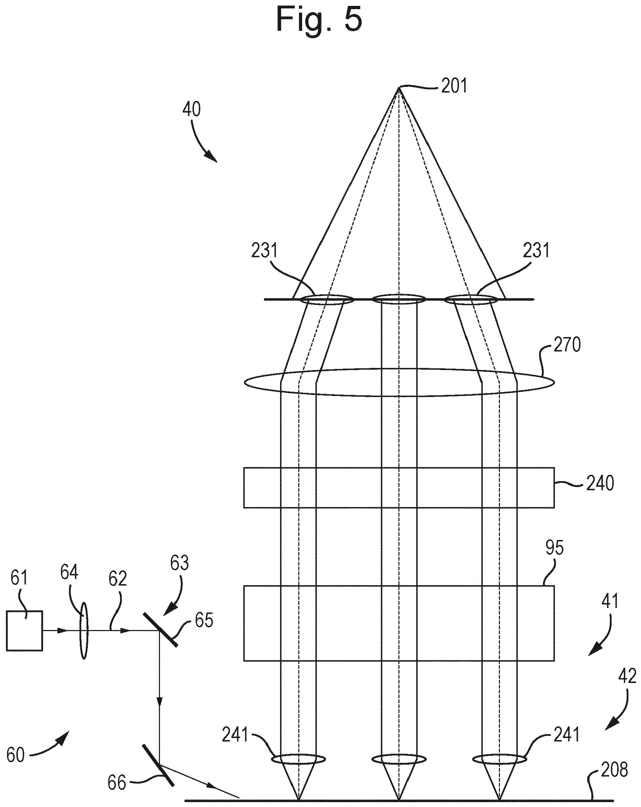

**FIG. 5** schematically depicts an electron apparatus 40 according to an embodiment. Features that are the same as those described above are given the same reference numerals. For conciseness, such features are not described in detail with reference to **FIG. 5****.** For example, the source 201, the macro collimator 270, the objective lens array 241 and the sample 208 may be as described above.

In an embodiment the electron apparatus 40 comprises an array of condenser lenses 231, or at least a beam limiting aperture array. (In an arrangement the macro-collimator may be located up-beam of the condenser lens array, or at least the beam limiting array.) The array of condenser lenses 231 (or at least the beam limiting aperture array) generates a plurality of sub-beams from the incidental beam from the source 201. (Note if item 231 is the beam limiting aperture array without any lensing function, the lensing function may be undertaken by the macro condenser 270). There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which electrons have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect. In an embodiment, the objective lens may have four or more plates which may function as electrodes.

As described above, in an embodiment the detector 240 is between the objective lens array 241 and the sample 208. The detector 240 may face the sample 208. Alternatively, as shown in **FIG. 5****,** in an embodiment the objective lens array 241, which comprises the plurality of objective lenses, is between the detector 240 and the sample 208.

In an embodiment a deflector array 95 is between the detector 240 and the objective lens array 241. In an embodiment the deflector array 95 comprises a Wien filter so that deflector array may be referred to as a beam separator. The deflector array 95 is configured to provide a magnetic field to disentangle the electrons projected to the sample 208 from the signal particles such as secondary electrons from the sample 208.

In an embodiment the detector 240 is configured to detect signal particles by reference to the energy of the electron, i.e. dependent on a band gap. Such a detector 240 may be called an indirect current detector. The signal electrons emitted from the sample 208 gain energy from the fields between the electrodes. The signal electrons have sufficient energy once they reach the detector 240.

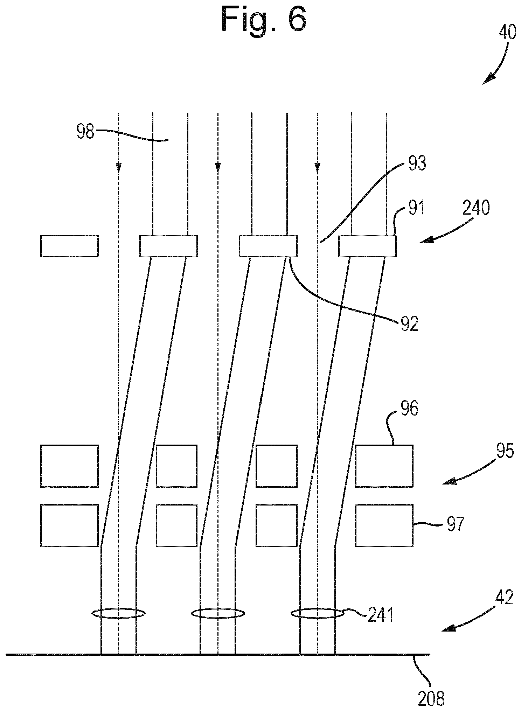

**FIG. 6** is a close-up view of part of the electron apparatus 40 shown in **FIG. 5****.** In an embodiment the detector 240 comprises an electron to photon converter array 91. The electron to photon converter array 91 comprises a plurality of scintillator elements such as fluorescent strips 92. Each fluorescent strip 92 is located in the plane of the electron to photon converter array 91. At least one fluorescent strip 92 is arranged between two adjacent electron beams projected towards the sample 208.

In an embodiment, the fluorescent strips 92 extend substantially in the horizontal direction (or orthogonal to the paths of the sub-beams). Alternatively, the electron to photon converter array 91 may comprise a plate of a fluorescent material with openings 93 for the projected electron beams.

The projected electron beams, indicated by dashed lines in **FIG. 6****,** are projected through the plane of the electron to photon converter array 91, via the openings 93 between the fluorescent strips 92, towards the deflector array 95.

In an embodiment the deflector array 95 comprises a magnetic deflector 96 and an electrostatic deflector 97. The electrostatic deflector 97 is configured to counteract the deflection of the magnetic deflector 96 for the projected electron beams transmitted towards the sample 208. Accordingly, the projected electron beams may be shifted to a small extent in the horizontal plane. The beams down-beam of the deflector array 95 are substantially parallel to the beams up-beam of the deflector array 95.

In an embodiment the objective lens array 241 comprises a plurality of plates for guiding signal electrons created in the sample 208 towards the deflector array 95. For the signal electrons, which travel in opposite direction with respect to the projected electron beams, the electrostatic deflector 97 does not counteract the deflection of the magnetic deflector 96. Instead, the deflections of the signal electrons by the electrostatic deflector 97 and the magnetic deflector 96 add up. Accordingly, the signal electrons are deflected to travel at an angle with respect to the optical axis in order to transmit the secondary electrons onto the fluorescent strips 92 of the detector 240.

At the fluorescent strips 92, photons are created upon incidence of the signal electrons such as secondary electrons. In an embodiment, the photons are transported from the fluorescent strip 92 to a photo detector (not shown) via a photon transport unit. In an embodiment, the photon transport unit comprises an array of optical fibers 98. Each optical fiber 98 comprises an end which is arranged adjacent or attached to one of the fluorescent strips 92 for coupling photons from the fluorescent strip 92 into the optical fiber 98, and another end which is arranged to project photons from the optical fiber 98 onto the photo detector.

The objective lens array 241 of any embodiment may comprise at least two electrodes in which are defined aperture arrays. In other words, the objective lens array comprises at least two electrodes with a plurality of holes or apertures. **FIG. 7** shows electrodes 242, 243 which are part of an exemplary objective lens array 241 having respective aperture arrays 245, 246. The position of each aperture in an electrode corresponds to the position of a corresponding aperture in another electrode. The corresponding apertures operate in use on the same beam, sub-beam or group of beams in the multi-beam. In other words, corresponding apertures in the at least two electrodes are aligned with and arranged along a sub-beam path, i.e. one of the sub-beam paths 220. Thus, the electrodes are each provided with apertures through which the respective sub-beam 211, 212, 213 propagates.

The objective lens array 241 may comprise two electrodes, as shown in **FIG. 7****,** or three electrodes, or may have more electrodes (not shown). An objective lens array 241 having only two electrodes can have lower aberration than an objective lens array 241 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. Such additional electrodes may be considered to form the control lens array 250. A benefit of two electrode lens over an Einzel lens is that the energy of an in-coming beam is not necessarily the same as an out-going beam. Beneficially the potential differences on such a two electrode lens array enables it to function as either an accelerating or a decelerating lens array.

Adjacent electrodes of the objective lens array 241 are spaced apart from each other along the sub-beam paths. The distance between adjacent electrodes, in which an insulating structure might be positioned as described below, is larger than the objective lens.

Preferably, each of the electrodes provided in the objective lens array 241 is a plate. The electrode may otherwise be described as a flat sheet. Preferably, each of the electrodes is planar. In other words, each of the electrodes will preferably be provided as a thin, flat plate, in the form of a plane. Of course, the electrodes are not required to be planar. For example, the electrode may bow due to the force due to the high electrostatic field. It is preferable to provide a planar electrode because this makes manufacturing of the electrodes easier as known fabrication methods can be used. Planar electrodes may also be preferable as they may provide more accurate alignment of apertures between different electrodes.

The objective lens array 241 can be configured to demagnify the electron beam by a factor greater than 10, desirably in the range of 50 to 100 or more.

A detector 240 is provided to detect signal electrons for example secondary and/or backscattered electrons emitted from the sample 208. The detector 240 is positioned between the objective lenses 234 and the sample 208. The detector 240 may otherwise be referred to as a detector array or a sensor array, and the terms "detector" and "sensor" are used interchangeably throughout the application.

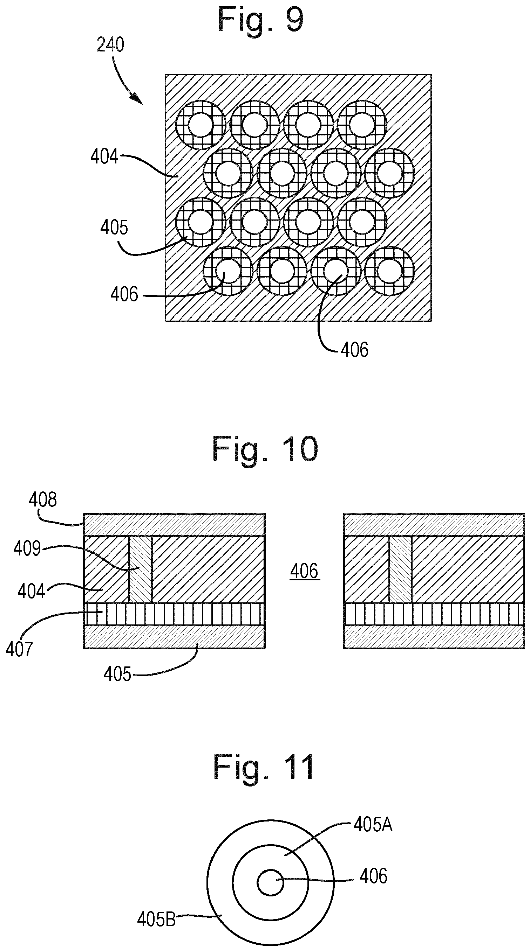

In an embodiment the electron-optical device 41 is configured to project a beam of electrons towards the sample 208. The electron-optical device 41 may comprise the objective lens array 241. The electron-optical device 41 may comprise the detector 240. The array of objective lenses (i.e. the objective lens array 241) may correspond with the array of detectors (i.e. the detector 240) and/or any of the beams (i.e. the sub-beams). As will be described with respect to **FIG. 9****,** the detector 240 may be an array of detector elements, each of which may be associated with an aperture in the plates of the objective lens array 241.

**FIG. 8** is a schematic view of part of the electron-optical device 41 of, for example, **FIG. 4** viewed in cross-section. **FIG. 8** shows a close-up view of the objective lens array 241 and the control lens array 250. As shown in **FIG. 8****,** in an embodiment the beam shaping aperture array 262 is associated with the objective lens array 241. The bean shaping array 262 may be down-beam of the objective lens array 241. For example, the beam shaping aperture array 262 may comprise a plate that is attached to an electrode of the objective lens array 241, preferably the down-beam electrode 243 of the objective lens array 241. The plate of the beam shaping aperture array 262 may be integrally formed with an electrode of the objective lens array 241, preferably the down-beam electrode 243 of the objective lens array 241. Alternatively, the beam shaping aperture array 262 may be distanced from the objective lens array 241. The beam shaping aperture array 262 may be formed as a separate component from any of the electrodes 242, 243 of the objective lens array 241.

As shown in **FIG. 8****,** in an embodiment the beam shaping aperture array 262 is down-beam of the objective lens array 241. In an alternative embodiment the beam shaping aperture array 262 is further up-beam, such as even up-beam of the objective lens array 241. For example, the beam shaping aperture array 262 may be connected to or formed integrally with the up-beam electrode 242 of the objective lens array 241. In an embodiment the beam shaping aperture array 262 is located between the objective lens array 241 and the control lens array 250.

As shown in **FIG. 8****,** the control lens array 250 is associated with the objective lens array 241. As described above, the control lens array 250 may be considered as providing electrodes additional to the electrodes 242, 243 of the objective lens array 241. The additional electrodes of the control lens array 250 allow further degrees of freedom for controlling the electron-optical parameters of the sub-beams. In an embodiment the control lens array 250 may be considered to be additional electrodes of the objective lens array 241 enabling additional functionality of the respective objective lenses of the objective lens array 241. In an arrangement such electrodes may be considered part of the objective lens array providing additional functionality to the objective lenses of the objective lens array 241. In such an arrangement, the control lens is considered to be part of the corresponding objective lens, even to the extent that the control lens is only referred to as being a part of the objective lens.

As shown in **FIG. 8****,** in an embodiment the control lens array 250 and the objective lens array 241 share a common electrode. In the arrangement shown in **FIG. 8****,** the control lens array 250 comprises three electrodes 253, 254, 255. In an embodiment the down-beam electrode 255 of the control lens array 250 and the up-beam electrode 242 of the objective lens array 241 form a common electrode. The same conductive plate may be used for both the down-beam electrode 255 of the control lens array 250 and the up-beam electrode 242 of the objective lens array 241. The common electrode arrangement allows for a particularly compact objective lens assembly. In an alternative embodiment the down-beam electrode 255 of the control lens array 250 is distanced from the up-beam electrode 242 of the objective lens array 241. The electrodes of the control lens array 250 may be separate from the electrodes of the objective lens array 241.

In the arrangement shown in **FIG. 8****,** the control lens array 250 comprises three electrodes 253, 254, 255. In alternative embodiment, the control lens array 250 may comprise one electrode or two electrodes, for example. Each additional plate or electrode of the control lens may enable the control lens array 250 to have an additional degree of freedom.

In an embodiment the controller 50 is configured to control the voltage applied to the middle electrode 254 and the down-beam electrode 255 of the control lens array 250 in order to adjust the focus of the incoming sub-beams.

In an embodiment the controller 50 is configured to control the objective lenses of the objective lens array 241 to operate as decelerating lenses. The controller 50 may control the voltages applied to the electrodes 242, 243 of the objective lens array 241 such that the objective lenses decelerate the electrons of the sub-beams that are projected toward the sample 208. The controller 50 is configured to adjust the voltages applied to the electrodes 242, 243 during use of the electron-optical device 41.

As shown in **FIG. 8****,** in an embodiment the electron-optical device 41 comprises the sub-beam forming array 252. The sub-beam forming array 252 is configured to split an electron beam into the multi-beam of electrons comprising the sub-beams. Thus the sub-beam forming array 252 generates sub-beams of the multi-beam of electrons from an electron beam, for example, from the electron source 201. In an alternative embodiment, the sub-beam forming array 252 is provided separately from the electron-optical device 41. The electron-optical device 41 and the sub-beam forming array 252 may be combined together in the electron apparatus 40.

In the arrangement shown in **FIG. 8****,** the sub-beam forming array 252 is associated with the control lens array 250. For example, the sub-beam forming array 252 may be associated with the up-beam electrode 253 of the control lens array 250. In an embodiment the sub-beam forming array 252 provides a most up-beam electrode 252 of the control lens array 250. For example, the sub-beam forming array 252 may comprise a plate that is connected to or is integrally formed with the up-beam electrode 253. In an alternative embodiment, the sub-beam forming array 252 is provided as a physically separate component from the electrodes 253, 254, 255 of the control lens array 250.

As shown in **FIG. 8****,** in an embodiment the sub-beam forming array 252 is up-beam of the control lens array 250. As shown in **FIG. 8****,** in an embodiment the electron-optical device 41 comprises the detector 240. The detector 240 may be formed as a detector array comprising a plurality of detector elements 405 at a position along the beam path configured to detect signal particles emitted from the sample 208. In an embodiment the detector elements 405 are associated with respective sub-beams of the multi-beam of electrons.

As shown in **FIG. 8****,** in an embodiment at least part of the detector 240 is between the control lens array 250 and the sample 208. That is the detector 240 may comprise at least two arrays each located at different positions along the primary beam path towards the sample 208. The detector arrays of such a detector 240 may thus be distributed at different positions of the electron-optical column for example as different detector arrays. In an embodiment, all of the detector array is between the control lens array 250 and the sample 208; that is no detector array of the detector 240 is located up-beam of the control lens array 250. In an embodiment, part of the detector 240 is between the control lens array 250 and the sample 208 and part of the detector 240 is up-beam of the control lens array 250. For example, **FIG. 6** shows an example in which the detector 240 has a detector array up-beam (with respect to the direction of primary or sub-beam towards the sample 208, i.e. the direction of the electrons projected toward the sample 208) of the control lens array 250. In an embodiment all of the detector 240 is up-beam of the control lens array 250.

As shown in **FIG. 8****,** in an embodiment at least part of the detector 240 (for example a detector array of the detector 240) is between the beam shaping aperture array 262 and the sample 208. For example, as shown in **FIG. 8** in an embodiment the detector 240 is associated with the objective lens array 241. The detector 240 may take the form of one detector array. In a different arrangement the detector 240 may have more than one detector array. At least one of the detector arrays is located up-beam of the detector array depicted in **FIG. 8****,** i.e. that directly faces a sample in use. Such a detector array located up-beam of a surface of the device 41 closest to a sample in use (e.g. an additional detector array) is not depicted in **FIG. 8****.** As mentioned, the detector 240 may form the final surface of the electron-optical device 41 up-beam of the sample 208. The detector 240 faces the sample 208; that is the detector elements in the detector array may face the sample 208. The detector 240 may be supported by a plate that is fixed relative to the down-beam electrode 243 of the objective lens array 241 and/or the beam shaping aperture array 262.

In an embodiment the controller 50 is configured to control the electron apparatus 40 to operate to detect signal particles emitted by the sample 208. As shown in **FIG. 8****,** the apertures of the beam shaping array 262 are dimensionally smaller than the respective apertures of the control lens array 250. The beam shaping array 262 having dimensionally smaller apertures enables the beam shaping array 262 to shape the beams down-beam of their generation by the sub-beam forming array 252. The beam shaping aperture array 262 provides the limiting factor for the current of electrons of the sub-beams that is projected toward the sample 208. During inspection, (i.e. the inspection mode), the beam shaping aperture array 262 is preferably proximate the sample 208 is configured to shape (e.g. limit) the sub-beams.

An exemplary detector 240 is described below. However, any reference to the detector 240 could be a single detector (i.e. at least one detector) or multiple detectors, for example positioned along the multi-beam path, as appropriate. The detector 240 may comprise detector elements 405 (e.g. sensor elements such as capture electrodes). The detector 240 may comprise any appropriate type of detector. For example, capture electrodes for example to detect directly electron charge, scintillators or PIN elements can be used. The detector 240 may be a direct current detector or an indirect current detector. The detector 240 may be a detector as described below in relation to **FIGS. 9-11****.**

The detector 240 may be positioned between the objective lens array 241 and the sample 208. The detector 240 is configured to be proximate the sample 208. The detector 240 may be very close to the sample 208. Alternatively, there may be a larger gap between, the detector 240 and the sample 208. The detector 240 may be positioned in the device so as to face the sample 208. Alternatively, the detector 240 may be positioned elsewhere in the electron-optical device 41 such that part of the electron-optical device that faces the sample 208 is other than, and thus is not, a detector. For example the detector 240 may have a part at least associated with an electrode of the objective lens array 241.

For a multi-beam system of the type shown in **FIGS. 2-5****,** preferably, a distance between the electron-optical column and the sample 208 is less than or equal to approximately 50 µm. The distance is determined as the distance from a surface of the sample 208 facing the electron-optical column and a surface of the electron-optical column facing the sample 208.

**FIG. 9** is a bottom view of the detector 240 which comprises a substrate 404 on which are provided a plurality of detector elements 405 each surrounding a beam aperture 406. The beam apertures 406 may be formed by etching through the substrate 404. In the arrangement shown in **FIG. 9****,** the beam apertures 406 are in a hexagonal close packed array. The beam apertures 406 can also be differently arranged, e.g. in a rectangular array. The beam arrangement of the hexagonal arrangement in **FIG. 9** may be more densely packed than a square beam arrangement. The detector elements 405 may be arranged in a rectangular array or a hexagonal array (Note: the beam arrangement may be referred to as a multi-beam arrangement. These arrangements may be referred to as the grid of the multi-beam).

In an embodiment the beam apertures 406 have a pitch P of at least 20 µm, optionally at least 50 µm, optionally at least 100 µm, optionally at least 200 µm and optionally 210 µm. A greater pitch allows for the diameter d of the beam apertures 406 to be greater. In an embodiment the beam apertures 406 have a pitch P of at most 1000 µm, optionally at most 500 µm, and optionally at most 250 µm. The pitch of the beam apertures 406 defines the pitch of the sub-beams of the multi-beam of sub-beams (or multi-beam of electrons) that is projected toward the sample 208. In an embodiment the sub-beams of the multi-beam of electrons have a pitch of at least 50 µm, optionally at least 100 µm, optionally at least 200 µm and optionally 210 µm. In an embodiment the beam apertures 406 have a diameter d that is less than the pitch P. In an embodiment the beam apertures 406 have a diameter d that is at least 10 µm, and optionally at least 20 µm. In an embodiment the beam apertures 406 have a diameter d that is at most 100 µm, optionally at most 50 µm, and optionally at most 30 µm. A smaller diameter d improves the resolution such that smaller defects can be detected.

**FIG. 10** depicts at a larger scale a part of the detector 240 in cross section. The detector elements 405 form the bottommost surface of the detector 240, i.e. closest to the sample 208. Between the detector elements 405 and the main body of the substrate 404 a logic layer 407 may be provided. At least part of the signal processing system may be incorporated into the logic layer 407.

A wiring layer 408 is provided on the backside of, or within, the substrate 404 and connected to the logic layer 407 by through-substrate vias 409. The number of through-substrate vias 409 need not be the same as the number of beam apertures 406. In particular if the electrode signals are digitized in the logic layer 407 only a small number of through-silicon vias may be required to provide a data bus. The wiring layer 408 can include control lines, data lines and power lines. It will be noted that in spite of the beam apertures 406 there is ample space for all necessary connections. The detection module 402 can also be fabricated using bipolar or other manufacturing techniques. A printed circuit board and/or other semiconductor chips may be provided on the backside of detector 240.

The integrated detector array described above is particularly advantageous when used with a tool having tunable landing energy as signal electron, e.g. secondary electron, capture can be optimized for a range of landing energies.

The detector 240 may be implemented by integrating a CMOS chip detector into a bottom electrode of the objective lens array 241. Integration of a detector 240 into the objective lens array 241 or other component of the electron-optical device 41 allows for the detection of electrons emitted in relation to multiple respective sub-beams. The CMOS chip is preferably orientated to face the sample (because of the small distance (e.g. 50 µm or less) between the sample and a bottom of the electron-optical column). In an embodiment, detector elements 405 to capture the signal electrons are formed in the surface metal layer of the CMOS device. The detector elements 405 can be formed in other layers. Power and control signals of the CMOS may be connected to the CMOS by through-silicon vias. For robustness, preferably a passive silicon substrate with holes shields the CMOS chip from high E-fields.

In order to maximize the detection efficiency it is desirable to make the surface of the detector elements 405 as large as possible, so that substantially all the area of the objective lens array 240 (excepting the apertures) is occupied by detector elements 405. Additionally or alternatively, each detector element 405 has a diameter substantially equal to the array pitch (i.e. the aperture array pitch described above in relation to the electrodes of the objective lens assembly 241); preferably with electrically isolating material separating the detector elements. Therefore, the diameter of each detector element may be less than approximately 600 µm, and preferably between approximately 50 µm and 500 µm. As described above, the pitch may be selected depending on the intended distance between the sample 208 and the detector 240. In an embodiment the outer shape of the detector element 405 is a circle, but this can be made a square to maximize the detection area. Also the diameter of the through-substrate via 409 can be minimized. A typical size of the electron beam is in the order of 5 to 15 micron.

In an embodiment, a single detector element 405 surrounds each beam aperture 406. In another embodiment, a plurality of detector elements 405 are provided around each beam aperture 406. The electrons captured by the detector elements 405 surrounding one beam aperture 406 may be combined into a single signal or used to generate independent signals. The detector elements 405 may be divided radially. The detector elements 405 may form a plurality of concentric annuluses or rings. The detector elements 405 may be divided angularly. The detector elements 405 may form a plurality of sector-like pieces or segments. The segments may be of similar angular size and/or similar area. The electrode elements may be separated both radially and angularly or in any other convenient manner.

However a larger surface for the detector elements 405 leads to a larger parasitic capacitance, so a lower bandwidth. For this reason it may be desirable to limit the outer diameter of the detector elements 405. Especially in case a larger detector element 405 gives only a slightly larger detection efficiency, but a significantly larger capacitance. A circular (annular) detector element 405 may provide a good compromise between collection efficiency and parasitic capacitance.

A larger outer diameter of the detector element 405 may also lead to a larger crosstalk (sensitivity to the signal of a neighboring hole). This can also be a reason to make the outer diameter of the detector element 405 smaller. Especially in case a larger detector element 405 gives only a slightly larger detection efficiency, but a significantly larger crosstalk.

The electron current collected by detector element 405 is amplified, for example by an amplifier such as a TIA.

The detector may be provided with multiple portions and more specifically, multiple detecting portions . The detector comprising multiple portions may be associated with one of the sub-beams 211, 212, 213. Thus, the multiple portions of one detector 240 may be configured to detect signal particles emitted from the sample 208 in relation to one of the primary beams (which may otherwise be referred to as sub-beams 211, 212, 213). In other words, the detector comprising multiple portions may be associated with one of the apertures in at least one of the electrodes of the objective lens assembly. More specifically, the detector 405 comprising multiple portions may be arranged around a single aperture 406 as shown in **FIG. 11****,** which provides an example of such a detector.

As shown in **FIG. 11****,** the detector element 405, in which an aperture 406 is defined and configured for the through passage of an electron beam, comprises an inner detecting portion 405A and an outer detecting portion 405B. The inner detecting portion 405A surrounds the aperture 406 of the detector. The outer detecting portion 405B is radially outwards of the inner detecting portion 405A. The shape of the detector may be generally circular. Thus, the inner detecting portion and the outer detecting portion may be concentric rings. So each portion is a concentric ring.

In an embodiment, the objective lens array 241 is an exchangeable module, either on its own or in combination with other elements such as the control lens array 250 and/or the detector 240 and/or the beam shaping aperture array 262 and/or the sub-beam forming array 252. In an arrangement the whole electron-optical device 41 may be exchangeable. The exchangeable module may be field replaceable, i.e. the module can be swapped for a new module by a field engineer. In an embodiment, multiple exchangeable modules are contained within the tool and can be swapped between operable and non-operable positions without opening the electron apparatus 40.

In an embodiment the exchangeable module comprises an electron-optical component, and specifically may be the electron-optical device, which is on a stage permitting actuation for positioning of the component. In an embodiment the exchangeable module comprises a stage. In an arrangement the stage and the exchangeable module may be an integral part of the tool 40. In an arrangement the exchangeable module is limited to the stage and the device, such as the electron-optical device, it supports. In an arrangement the stage is removable. In an alternative design the exchangeable module comprising the stage is removable. The part of the electron apparatus 40 for the exchangeable module is isolatable, that is the part of the electron apparatus 40 is defined by a valve up-beam and a valve down-beam of the exchangeable module. The valves can be operated to isolate the environment between the valves from the vacuum up-beam and down-beam of the valves respectively enabling the exchangeable module to be removed from the electron apparatus 40 whilst maintaining the vacuum up-beam and down-beam of the part of the electron apparatus 40 associated with the exchangeable module. In an embodiment the exchangeable module comprises a stage. The stage is configured to support a device, such as the electron-optical device, relative to the beam path. In an embodiment the module comprises one or more actuators. The actuators are associated with the stage. The actuators are configured to move the device relative to the beam path. Such actuation may be used to align the device and the beam path with respect to each other.

In some embodiments, one or more aberration correctors are provided that reduce one or more aberrations in the sub-beams. The one or more aberration correctors may be provided in any of the embodiments, e.g. as part of the electron-optical device, and/or as part of an optical lens array assembly, and/or as part of an assessment system. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. up-beam or down-beam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses are vertically close or coincident with the beam apertures. A challenge with positioning correctors at or near the condenser lenses, however, is that the sub-beams each have relatively large sectional areas and relatively small pitch at this location, relative to locations further down-beam. The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference.

In some embodiments, each of at least a subset of the aberration correctors is integrated with, or directly adjacent to, the objective lens array 241. In an embodiment, these aberration correctors reduce one or more of the following: field curvature; focus error; and astigmatism. Additionally or alternatively, one or more scanning deflectors (not shown) may be integrated with, or directly adjacent to, the objective lens array 241 for scanning the sub-beams 211, 212, 213 relative to, for example over, the sample 208. In an embodiment, the scanning deflectors described in US 2010/0276606, which document is hereby incorporated by reference in its entirety, may be used.

**FIG. 12** is a schematic diagram of an exemplary electron apparatus 40 according to an embodiment. The electron apparatus 40 is configured to project a multi-beam of electrons along an electron multi-beam path toward the sample 208. The multi-beam path may comprise a primary multi-beam path corresponding to the path of the primary electron beam emitted from the source 201. The multi-beam path may comprise electron sub-beam paths corresponding to the paths of the sub-beams derived from the primary electron beam.

Features of the electron apparatus 40 that are described above are not described again below, so as to avoid repetition. In an embodiment the electron apparatus 40 comprises a source 201, a macro collimator 270, a macro deflector 265, a sub-beam forming array 252, a control lens array 250, an objective lens array 241 and a beam shaping aperture array 262 as described above with reference to **FIG. 4****.** The macro collimator 270, the macro deflector 265, the sub-beam forming array 252, the control lens array 250, the objective lens array 241 and the beam shaping aperture array 262 may be comprised in the electron-optical device 41. The sub-beam forming array 252, the control lens array 250, the objective lens array 241 and the beam shaping aperture array 262 may be integrated together, for example in the electron-optical device 41 as described above with reference to **FIG. 8****.** The electron apparatus 40 may feature a detector 240, for example in the electron-optical device 41.

As shown in **FIG. 12****,** in an embodiment the electron apparatus 40 comprises a tube 70 (which may also be called a liner tube or a booster tube). In an embodiment the tube 70 is arranged to surround the multi-beam path. The tube 70 surrounds the multi-beam path for example when viewed along the primary axis of the electron apparatus 40, i.e. in the direction of the electron beam. In an embodiment the tube 70 is configured to surround only part of the multi-beam path, i.e. part of the multi-beam path along the length of the multi-beam path. For example, as shown in **FIG. 12****,** in an embodiment the tube 70 surrounds the part of the multi-beam path from the source 201 to just above the sub-beam forming array 252. As shown in **FIGS. 13-16****,** the tube 70 may surround alternative parts, e.g. lengths, of the multi-beam path.

In an embodiment the tube 70 is configured to operate at a first potential difference from ground (or liner potential difference). The tube 70 may be connected to a potential source to set the tube 70 at the first potential difference. The tube 70 may be electrically connected to the controller 50. In an embodiment the tube 70 is configured to accelerate the electron beam toward the sample 208. In an embodiment the controller 50 is configured to control the first potential difference. The first potential difference may be controlled so as to control the acceleration of the electron beam toward the sample 208. In embodiments the electric potential of various elements of the electron apparatus 40 are controlled. Each of these controlled elements is connected, or connectable, to a potential source. The controller 50 (or another controller) is configured to control the potential applied to the respective element.

The tube 70 may be at high voltage. For example, the first potential difference may be greater than 100V, optionally at least 200V, optionally at least 500V, optionally at least 1kV, optionally at least 2kV, optionally at least 5kV, optionally at least 10kV, optionally at least 20kV, optionally at least 30kV, and optionally at least 60kV. When the charged particles are negatively charged e.g. electrons, the tube 70 may be at a high positive voltage. Alternatively, when the charged particles are positively charged, the tube 70 may be at a high negative voltage. The tube 70 is configured to cause the electrons of the electron beam to travel through the electron apparatus 40 (i.e. from the source 201 to the sample 208) at high energy.

In an embodiment the electron apparatus 40 comprises a support 207, for example as described above with reference to **FIG. 2****.** In an embodiment the support 207 is configured to support the sample 208 at a second potential difference from ground (or at sample potential difference). The second potential difference is different from the first potential difference. In an embodiment the first potential difference and the second potential difference have a difference so as to accelerate the electrons of the multi-beam towards the sample 208. In an embodiment the controller 50 is configured to control the first potential difference and the second potential difference. The first potential difference and the second potential difference may be controlled so as to control the acceleration of the electron beam toward the sample 208. Thus, the sample potential difference and the liner potential difference are different; the difference between the sample and the liner potential differences may accelerate the multi-beam of electrons towards the sample 208.

In an embodiment the first potential difference is greater than the second potential difference. That is the difference of the linear potential from ground is greater than the sample potential difference from ground. The second potential difference may be less than half of the first potential difference. In an embodiment the second potential difference is substantially zero. The sample 208 may be held at ground potential. Alternatively, the sample 208 may be at a low voltage. For example, the second potential difference may be at most 100V, optionally at most 50V, optionally at most 20V, optionally at most 10V and optionally at most 5V.

An embodiment of the invention is expected to reduce the risk of damaging the sample 208 and features of the electron apparatus 40 such as of the electron-optical device 41 which may include the detector 240 positioned very close to the sample 208. The lower voltage of the sample 208 reduces the possibility of electrical breakdown with or in the immediate environment of the sample 208. This can reduce the possibility of the sample 208 being damaged. The risk of damage to components of the electron-optical device 41 such as the detector 240 (which may feature delicate electronic elements) may be reduced.

In an embodiment the electron apparatus 40 comprises a motorized stage 209, for example as described above with reference to **FIG. 2****.** Movement of the stage 209 and, for example a sample 208 on the stage 209, relative to the electron apparatus 40, especially features proximate to the sample 208, such as the detector 240, may be at risk of damage from electrical discharge at least in their environment. Such risk of discharge may be increased with variations in positioning of elements of the stage 209 and the electron apparatus 40 during relative motion.

An embodiment of the invention is expected to simplify the design of the motorized stage 209. By providing the sample 208 at a lower voltage, the motorized stage 209 may similarly be at a low voltage, e.g. ground. The design of electrical connection to and within the motorized stage 209 may be simplified. In particular the possibility of electrical breakdown between the motorized stage and components at ground is reduced because the motorized stage 209 is at a lower voltage. Thus the risk of damage to the sample 208 supported by the stage 209, the stage 209, and elements of the electron-optical device 41 close to the stage 209 is desirably reduced. This reduces the need for connections to be designed specifically for high voltage environments.

As described above and shown in **FIG. 12****,** in an embodiment the electron source 201 comprises a cathode 121 and an anode 122 (which may also be called an extractor or an extractor electrode). The cathode 121 and the anode 122 are configured to operate with a potential difference between them. The cathode 121 is configured to emit the electron beam. The anode 122 is configured to accelerate the electron beam toward the sample 208. Note, this source arrangement is a simplified arrangement. The source 201 may have a different arrangement and other electrodes, so long as the source 201 has a most down-beam source electrode, which is here referred to as the anode 122.

In an embodiment the electron beam is extracted to high energy. In particular, the electron beam from the cathode 121 may be accelerated in the source (e.g. by the anode 122), and thus extracted from the electron source 201 as a high energy electron beam. The electron apparatus 40 is configured such that the electrons of the electron beam travel through the electron apparatus 40 at high energy. An embodiment of the invention is expected to maintain the resolution of the inspection of the sample 208. The alternative possibility of extracting the electron beam only to low energy is known. This means that the electron beam is at low energy along the multi-beam path through the electron apparatus 40 towards the sample 208. This can increase the impact of chromatic aberration and electron-electron interaction, which can lower resolution. An embodiment of the invention is expected to achieve lower chromatic aberration and/or higher resolution compared to such an alternative configuration.

In an embodiment the cathode 121 is configured to operate at a lower voltage than the tube 70. Thus, the cathode 121 is configured to operate at a lower voltage than a cathode potential difference. For example, the cathode 121 may be at a potential difference of at most 15kV, optionally at most 10kV, optionally at most 5kV, optionally at most 2kV and optionally at most 1kV from ground. The cathode 121 may be configured to operate at a negative voltage.

In an embodiment the potential difference between the sample 208 and the cathode 121 is less than the potential difference between the sample 208 and the tube 70. The potentials of the cathode 121, the tube 70 and the sample 208 (e.g. the sample potential difference, the cathode potential difference and the liner potential difference) are controlled such that the electrons of the electron beam decelerate before reaching the sample 208. The electron apparatus 40 is configured such that the electrons land on the sample 208 (i.e. are incident with the sample 208) with a low landing energy, for example of the order of about IkeV.

In an embodiment the potential difference between the tube 70 and the cathode 121 is at least 1kV, optionally at least 2kV, optionally at least 5kV, optionally at least 10kV optionally at least 20kV, optionally at least 30kV, and optionally at least 60kV.. The tube 70 is thus configured such that the electrons of the electron beam travel through the electron apparatus 40, i.e. at high energy. This helps to reduce chromatic aberration and electron-electron interaction, thereby improving resolution.

In an embodiment the tube 70 is at the same electric potential as the anode 122. Alternatively, there may be a non-zero potential difference between the anode 122 and the tube 70. The potential difference between the tube 70 and the anode 122 may be at most 100V, optionally at most 50V, optionally at most 20V, optionally at most 10V and optionally at most 5V. The most up-beam end of the tube 70 is the part of the tube 70 that is located closest to the anode 122. The most up-beam end of the tube 70 may be referred to as a termination 71 of the tube 70. The tube 70 may terminate at its most up-beam end, or termination 71, in a region where there is a small electric field or no electric field. This can help to reduce, or even prevent, any lensing effect on the electron beam which may otherwise be caused by such an electric field.

As shown in **FIG. 12****,** in an embodiment the tube 70 is electrically connected to the anode 122. By electrically connecting the tub 70 to the anode 122, there is no electric field formed between the source 201 and the tube 70. Any unwanted lensing effect up-beam of the tube 70 is avoided. An embodiment of the invention is expected to avoid an undue increase in the number of parts of the electron apparatus 40. The tube 70 may be formed together with the anode 122. The tube 70 and the anode 122 may be integral. This can simplify the structure of the electron apparatus 40.

Alternatively, the tube 70 may be separated from the source 201. The tube 70 may be distanced along the axial direction from the anode 122. When the anode 122 and the tube 70 are at the same potential, no electric field is formed between the tube 70 and the anode 122. Alternatively, when there is a potential difference between the tube 70 and the anode 122, there may be an electric field formed between the tube 70 and the anode 122. In an embodiment the gap in the axial direction between the anode 122 and the tube 70 is at most 1mm. By providing that the gap is small, any electric field formed between the tube 70 and the anode 122 is particularly confined to a small region. Preferably the small region is remote from, i.e. removed from, the multi-beam path of the multi-beam of electrons. This may help to reduce any undesirable effect of the electric field on the electron beam.

As shown in **FIG. 12****,** in an embodiment at least part of the electron-optical device 41 is down-beam of the most down-beam end of the tube 70, or an ending 72 of the tube 70. The part or parts of the electron-optical device 41 down-beam of the most down-beam ending 72 of the tube 70 form a down-beam device 42 (or an electron-optical assembly). In the arrangement shown in **FIG. 12****,** the sub-beam forming array 252, the control lens array 250, the objective lens array 241 and the beam shaping aperture array 262 are down-beam of the ending 72 of the tube 70. The down-beam device 42 comprises the sub-beam forming array 252, the control lens array 250, the objective lens array 241 and the beam shaping aperture array 262. There may be a large potential difference between the tube 70 and the sample 208. The down-beam device 42 is between the tube 70 and the sample 208. In an embodiment the down-beam device 42 is configured to decelerate the electron beam.

In an embodiment the potential difference between the ending 72 (i.e. the most down-beam end of the tube 70) and the most up-beam electrostatic component of the down-beam device 42 is less than the liner potential difference (e.g. the first potential difference). For example, in the arrangement shown in **FIG. 12****,** the most up-beam component of the down-beam device 42 is the sub-beam forming array 252. Alternative arrangements exist which are described later herein. In general, in an embodiment the most up-beam component of the down-beam device 42 may be an up-beam plate or associated plate in which are defined an array of apertures for the paths of the sub-beams of the multi-beam of electrons. The up-beam plate (or associated plate) may be associated with the ending 72 of the tube 70.

In an embodiment, the potential difference between the ending 72 of the tube 70 and the up-beam plate of the down-beam device 42 is less than the liner potential difference (i.e. the first potential difference). The potential difference between the ending 72 of the tube 70 and the most up-beam electrostatic component of the down-beam device 42 may be at most 100V, optionally at most 50V. optionally at most 20V, optionally at most 10V, optionally at most 5V and optionally substantially zero. In an embodiment the most up-beam electrostatic component of the down-beam device 42 is at the same electric potential as the ending 72 of the tube 70.

An embodiment of the invention is intended such that the electron beam passes through the electron apparatus 40 without unduly introducing undesirable lensing effects on the electron beam. The ending 72 of the tube 70 may be in a region that has a small electric field or no electric field. This can help reduce or avoid any lensing effect on the electron beam that could be caused by an electric field between the tube 70, e.g. the ending 72, and the down-beam device 42, for example between the ending 72 and the up-beam plate. (Note the down-beam device 42 is located between the tube 70 and the sample 208).

As shown in **FIG. 12****,** in an embodiment the down-beam device 42 comprises a plurality of plates in each of which are defined an array of apertures for the paths of the sub-beams of electrons, in the multi-beam. The plurality of plates comprise the up-beam plate (or associated plate). For example, the down-beam device may comprise plates forming the sub-beam forming array 252, the electrodes of the control lens array 250, the electrodes of the objective lens array 241 and the beam-shaping aperture array 262. In an embodiment the apertures of the plates are aligned with each other. In an embodiment the apertures of at least one of the plates form slits. The slits may be aligned with lines of sub-beams in the arrangement of sub-beam paths in the multi-beam of electrons.

As shown in **FIG. 12****,** in an embodiment the tube 70, specifically the ending 72 is spaced apart from the down-beam device 42. The separation between the ending 72 and the down-beam device 42 may make it easier to replace part or all of the electron-optical device 41. For example, the ending 72 of the tube 70 is distanced from the sub-beam forming array 252. In an embodiment the gap between the ending 72 and the component of the electron-optical device 41 that is immediately down-beam (along a beam path towards the sample 208) is at most 1mm. Any electric field between the down-beam end of the tube 70 and the down-beam device 42 may be confined to a small distance (i.e. the length of the gap immediately down-beam of the tube 70) preferably remote from the path of the beam through device. This arrangement may help to reduce or even prevent the effect of any electric field between the ending 72 and the electron-optical device 41.

In an alternative embodiment the tube 70 is electrically connected to the electron-optical device 41 that is down-beam of the tube 70, e.g. the ending 72. For example, the tube 70 may be structurally connected to the associated plate, for example the sub-beam forming array 252. The tube 70 may be integral with the associated plate.

As shown in **FIG. 12****,** in an embodiment the macro collimator 270 comprises a magnetic component (which may also be referred to as a magnetic element, a magnetic part or a magnetic portion). The magnetic component, for example its operation on the path of multi-beam of electrons, is unaffected by the tube 70. The macro collimator 270 may be located outside of the tube 70. The tube 70 is located radially inwardly of the macro collimator 270, for example relative to the path of the multi-beam of electrons. An embodiment of the invention is expected to maintain (e.g. not unduly increase) the width of the electron apparatus 40. Alternatively, the tube 70 may be located radially outwardly of the macro collimator 270; although such an arrangement is less preferred because the whole magnetic lens would need to be in vacuum and set at a potential of the tube 70. The inventors note that such an arrangement is likely to introduce unnecessary engineering complexities. Thus having the tube 70 radially inward of the macro collimator 270 is preferred.

In an alternative embodiment the macro collimator 270 comprises an electrostatic component. Such an electrostatic component may be affected by the tube 70, for example its shielding of electrostatic fields external to the tube 70 relative to the path of the multi-beam of electrons. In an embodiment the electrostatic component of the macro collimator 270 is located within the tube 70. The macro collimator 270 is configured to act on the electron beam without being hindered, for example the electrostatic fields generated by the macro collimator 270 being shielded by the tube 70.

It is noted that an alternative embodiment exists in which an electrostatic collimator array is provided integrated into the electron-optical device 41. The collimator array (not depicted) may be associated with the beam forming array 252 and/or the control lens array 250. In an arrangement an electrostatic collimator of the array is associated with the path of a sub-beam of the multi-beam.

In an embodiment the tube 70 comprises at least one section, each section extending along different positions along the multi-beam path and surrounding the multi-beam path. In an embodiment the macro collimator 270 adjoins at least one section of the tube 70. For example the macro collimator 270 may be located between a section of the tube 70 and an adjoining component of the electron-optical device 41. In an embodiment the macro collimator 270 is between adjoining sections of the tube 70.

In an embodiment the electron apparatus 40 comprises a macro scan deflector 265. The macro scan deflector 265 is configured to deflect respective portions of the electron beam. The different portions of the beam correspond to different sub-beams further down-beam. Deflection of the portions by the macro scan deflector 265 thus causes deflection of the respective sub-beams of electrons, in the multi-beam, to be scanned relative to, for example over, the sample 208. As shown in **FIG. 12****,** in an embodiment the macro scan deflector 265 is up-beam of the ending 72 of the tube 70.

As shown in **FIG. 12****,** in an embodiment the macro scan deflector 265 comprises a magnetic deflector (which may also be referred to as a magnetic component, a magnetic element, a magnetic part or a magnetic portion). The magnetic deflector, or at least the magnetic field generated by the magnetic deflector, is unaffected by the tube 70. That is the magnetic field generated by the magnetic deflector operates on the electrons along the path of the beam. The macro scan deflector 265 may be located outside of the tube 70. The tube 70 may be located radially inwardly of the macro scan deflector 265. An embodiment of the invention is expected to maintain (e.g. not unduly increase) the width of the electron apparatus 40. Alternatively, the tube 70 may be located radially outwardly of the macro scan deflector 265; although such an arrangement is less preferred because the whole magnetic scan deflector would need to be in vacuum and set at a potential of the tube 70. The inventors note that such an arrangement is likely to introduce unnecessary engineering complexities. Thus having the tube 70 radially inward of the magnetic scan deflector 265 is preferred.

In an alternative embodiment a scan deflector comprising an array of deflectors may be provided instead of a macro scan deflector. Such an array of deflectors is provided within the electron-optical device 41 as an array of scan deflectors 260 as depicted in **FIG. 3****.** Such an array of scan deflectors may be associated with an objective lens array, for example in which a deflector of the array is associated with each beam of the multi-beam.

In an embodiment the potential difference between the most down-beam component of the electron-optical device 41 and ground is less than the first potential difference (i.e. the linear potential difference). The components of the electron-optical device 41 down-beam of the tube 70 are configured to decelerate the electron beam. The most down-beam component of the electron-optical device 41, or in other words the component that in use faces a sample 208, may have a potential close to that of the sample 208 and/or close to ground. In an embodiment the most down-beam component is a plate of the down-beam device 42. For example, the most down-beam component may comprise at least part of the detector 240.

As described above, the electron-optical device 41 comprises an objective lens array 241 comprising a plurality of objective lenses configured to focus respective sub-beams of the multi-beam of electrons on the sample 208. The objective lens array 241 is down-beam of the tube 70. The down-beam device 42 comprises the objective lens array 241. The down-beam device 42 may be referred to as an objective lens assembly.

The ending 72 of the tube 70 is in a region with small or no electric fields. Preferably any generated electrically field is remote, for example radially distant, from the path of the electrons in the beam from the source. The objective lenses focus the sub-beams onto the sample 208. It is not necessary, indeed it is even preferable to avoid introduction of aberrations to the sub-beams, for the tube 70 to be used to form electric fields that focus the sub-beams onto the sample 208.

**FIG. 13** is a schematic diagram of an exemplary electron apparatus 40 according to an embodiment. The electron apparatus 40 is configured to project a multi-beam of electrons along a multi-beam path toward the sample 208. Features of the electron apparatus 40 that are described above with reference to **FIG. 12** are not described again below, so as to avoid repetition. Below are described features that are generally only differences from the arrangement shown in **FIG. 12****.**

In an embodiment the macro scan deflector 265 comprises an electrostatic component, desirably a macro electrostatic component. In the present arrangement, at the position of the beam path, the beam is a single beam of electrons suited for operation on by a macro scan deflector 265. Performance of such an electrostatic component may be affected by the tube 70 because, for example, the tube 70 is likely to shield some or all of the electric field generated by the electrostatic component. In an embodiment the tube 70 comprises at least one section, each section extending along different positions along the multi-beam path and surrounding the multi-beam path. As shown in **FIG. 13****,** in an embodiment the tube 70 comprises a plurality of sections 70a, 70b extending along different positions along the multi-beam path. Each section 70a, 70b surrounds the multi-beam path. Each section 70a, 70b of the tube 70 has a termination 71 at its upper end and an ending 72 at its lower end.

For example, in the arrangement shown in **FIG. 13** the tube 70 comprises two sections 70a, 70b: an up-beam section 70a and an down-beam section 70b. The up-beam section 70a extends from the termination 71 of the up-beam -section 70a. The termination 71 of the up-beam section 70a may be from the source 201 or from immediately down-beam of the source 201. The down-beam section 70b extends to an ending 72 of the down-beam section 70b. The ending of the down-beam section may be at or close to the associated plate for example the sub-beam forming array 252 or to immediately up-beam of the associated plate. In an embodiment the number of sections of the tube 70 is more than two as depicted in **FIG. 13****,** for example three, four or more than four. As shown in **FIG. 13****,** in an embodiment the sections 70a, 70b are positioned such that there is a gap in the axial direction between them, for example between a termination 71 and an ending 72 of adjoining sections. Alternatively, one or more pairs of adjacent sections of the tube 70 may overlap.

As shown in **FIG. 13****,** in an embodiment the electron-optical device 41 comprises at least one electrostatic component located between adjacent sections 70a, 70b of the tube 70. For example, in the arrangement shown in **FIG. 13****,** the macro scan deflector 265 comprises an electrostatic component and is located between adjacent sections 70a, 70b of the tube 70. That is the electrostatic component is located between a termination 71 and an ending 72 of adjacent sections 70a 70b. It is not necessary to increase the diameter of the tube 70 in order to surround the macro scan deflector 265. An embodiment of the invention is expected to maintain the width of the electron apparatus 40. In an arrangement of more than two sections, there may be an electrostatic electron-optical component of the electron apparatus 40 between an adjoining termination 71 and ending 72 of different sections.

The electrostatic component that is located between adjacent sections 70a, 70b of the tube 70 can act on the electron beam without being hindered by the tube 70; that is without the tube shielding or at least interfering with the electrostatic field generated by the component. In an embodiment the electrostatic component is at the same electric potential as at least one of the sections 70a, 70b of the tube 70 between which the electrostatic component is located. In an embodiment the electrostatic component is at the same electric potential as both of the sections 70a, 70b of the tube 70 between which the electrostatic component is located, for example as depicted in **FIG. 13****.** This can help to reduce or avoid unwanted electric fields being formed near the electrostatic component. Desirably this helps reduce or prevent unwanted aberrations or distortions to the beam of electrons. In an alternative embodiment, there may be a relatively small potential difference (e.g. no more than several hundreds of volts for example 1kV, desirably no more than 100V) between the electrostatic component and the adjoining sections 70a, 70b of the tube 70, i.e. the termination 71 on either side of the gap, between which the electrostatic component is located.

In an embodiment the electrostatic component is distanced from each of the sections 70a, 70b in the axial direction by no more than 1mm. Any unwanted electric fields may be confined to small axial distances, which are preferably radially remote from the path of the beam of electrons, so as to reduce if not prevent effect of any generated electric fields on the electron beam.

In an alternative embodiment the electrostatic component of the macro scan deflector 265 is located within the tube 70. The macro scan deflector 265 is configured to act on the electron beam without being hindered by the tube 70; that is the field generated by the electrostatic macro scan deflector 265 may operate on the beam of electrons without being shielded and thus hindered by the tube 70. However, this embodiment may be less preferred because it requires electrical connections within the shielding of the tube 70.

In a variation, the macro scan deflector 265 may have magnetic and electrostatic components. In an embodiment, the arrangement may take the form as described with reference to and as depicted in **FIG. 12** with the electrostatic component within the tube 70. In an alternative embodiment, the arrangement make take the form as described with reference to and as depicted in **FIG. 13** with the magnetic component substantially around or even surrounding the electrostatic element between the up-beam section 70a and the down-beam section 70b.

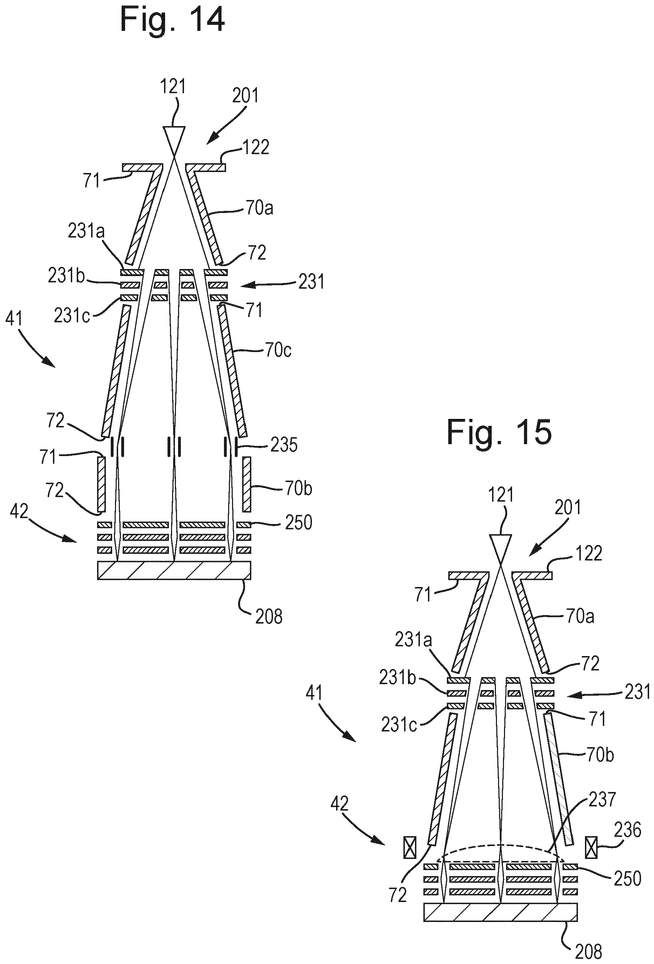

**FIG. 14** is a schematic diagram of an exemplary electron apparatus 40 according to an embodiment. The electron apparatus 40 is configured to project a multi-beam of electrons along a multi-beam path toward the sample 208. Features of the electron apparatus 40 that are described above are not described again herein, so as to avoid repetition. In an embodiment the electron apparatus 40 comprises a source 201, an array of condenser lenses 231, an array of deflectors 235, a control lens array 250, an array of scan deflectors 260 and an objective lens array 241 as described above with reference to the embodiments described with **FIGS. 3** or **5** and **6.** What characterizes these embodiments from the arrangement shown in and described with reference to **FIGS. 4****,** **12 and 13****,** is that the sub-beams of electrons (i.e. the multi-beam of electrons) is generated up-beam of the ending of the tube 70, i.e. up-beam of the ending of a down-beam most section 70n of the tube 70.

In this arrangement, the control lens array 250, the array of scan deflectors 260, the objective lens array 241 and the detector array 240 may be comprised in the electron-optical device 41. The control lens array 250, the array of scan deflectors 260 and the objective lens array 241 and optionally the array of deflectors 235 may be integrated together.

As shown in **FIG. 14****,** in an embodiment the tube 70 comprises at least three sections 70a, 70b, 70c which may be referred to as an up-beam section 70a, an intermediate section 70c and a down-beam section 70b. The sections may have features as described above with reference to **FIG. 13****.** In addition to the up-beam section 70a and the down-beam section 70b shown in **FIG. 13****,** the arrangement shown in **FIG. 14****,** comprises the intermediate section 70c.

As described above with reference to **FIG. 13****,** in an embodiment the electron-optical device 41 comprises at least one electrostatic component located between adjacent sections 70a, 70b, 70c of the tube 70. As shown in **FIG. 14****,** in an embodiment the at least one electrostatic component located between adjacent sections 70a, 70c of the tube 70 comprises the array of condenser lenses 231. The condenser lenses are configured to direct electrons of respective sub-beams of electrons of the multi-beam to respective intermediate foci. The intermediate foci may be associated with the deflector array 235 for example as later described herein. In an embodiment each condenser lens corresponds to a number of corresponding apertures in different plates along a sub-beam path of electrons.

In an embodiment the sub-beams of electrons in the multi-beam are formed up-beam of the most down-beam end of the tube 70. For example, the sub-beams may be generated at the array of condenser lenses 231, preferably a sub-beam forming array which may either be separate from the plates of the condenser lens array or an up-beam most plate of the condenser lens array 231, i.e. integral to the condenser lens array.

In an embodiment at least one of the electrodes of the array of condenser lenses 231 is at substantially the same potential as at least one of the sections 70a, 70c of the tube 70 between which the array of condenser lenses 231 is located. That is an electrode or plate of the condenser lens array that is an up-beam most or down-beam most electrode of the condenser lens array may be the same potential as the adjacent section 70a, 70c of the tube 70. As described above, in an embodiment the array of condenser lenses 231 is formed of three plate arrays 231a, 231b, 231c in which the potential differences are controlled such that the electrons in the sub-beams have the same energy on entering a respective condenser lens as on leaving the respective condenser lens. This lens arrangement may be referred to as an Einzel lens. In an embodiment the most up-beam plate array 231a is at substantially the same potential as the ending 72 of the up-beam section 70a of the tube 70. In a variation there may be a small (e.g. no more than 100V) potential difference between the most up-beam plate array 231a and the up-beam section 70a of the tube 70. In an embodiment the most down-beam plate array 231c is at substantially the same potential as the intermediate section 70c of the tube 70. In a variation there may be a small (e.g. no more than 100V) potential difference between the most down-beam plate array 231c and the intermediate section 70c of the tube 70. An embodiment of the invention is expected to minimize any unwanted electric fields at the terminations 71 and endings 72 of the sections 70a, 70b, 70c of the tube 70, for example specifically operating or acting on the paths of the beam and sub-beams of electrons.

As shown in **FIG. 14****,** in an embodiment the at least one electrostatic component located between adjacent sections 70b, 70c of the tube 70 comprises an array of deflectors 235. In an embodiment the deflectors are configured to deflect respective sub-beams of electrons in the multi-beam to cause the sub-beams to be scanned relative to, for example over, the sample 208. In an embodiment the deflectors are configured to additionally or alternatively collimate respective sub-beams of the multi-beam of electrons. As shown in **FIG. 14****,** in an embodiment the deflectors are located at or near an intermediate focal plane comprising the intermediate foci.

In an embodiment the array of deflectors 235 is at substantially the same potential as at least one of, optionally both of, the adjacent sections 70b, 70c of the tube 70 between which the array of deflectors 235 is located. In an embodiment the array of deflectors 235 is at substantially the same potential as the intermediate section 70c of the tube 70. In a variation, there may be a small (e.g. no more than 100V) potential difference between the array of deflectors 235 and the intermediate section 70c of the tube 70. In an embodiment the array of deflectors 235 is at substantially the same potential as the most down-beam section 70b of the tube 70. In a variation, there may be a small (e.g. no more than 100V) potential difference between the array of deflectors 235 and the most down-beam section 70b of the tube 70. An embodiment of the invention is expected to minimize any unwanted electric fields at the terminations 71 and endings 72 of the sections 70a, 70b, 70c of the tube 70, for example specifically operating or acting on the paths of the beam and sub-beams of electrons.

In an embodiment the array of deflectors 235 comprises an electrostatic component. By providing the array of deflectors 235 between sections 70b, 70c of the tube 70, the operation of the array of deflectors 235 is unhindered by the tube 70. The deflector array 235 is positioned with respect to the tube 70 such that the tube 70 does not shield the electrostatic fields generated by the array of deflectors 235 so that the deflectors may operate on the sub-beams of electrons, in the multi-beam.

**FIG. 15** is a schematic diagram of an exemplary electron apparatus 40 according to an embodiment. The electron apparatus 40 is configured to project a multi-beam of electrons along a multi-beam path toward the sample 208. Features of the electron apparatus 40 that are described above with reference to **FIG. 14****,** for example that are described expressly with reference to **FIG. 14** and that are described in other embodiments to which the description of **FIG. 14** refers, are not described again below, so as to avoid repetition. That is the description below refers just to differences with respect to the arrangement shown in and described with reference to **FIG. 14****.**

As shown in **FIG. 15****,** in an embodiment the electron apparatus 40 comprises a macro scan deflector 236. The macro scan deflector 236 is intended to replace the function of the deflector array 235 for example in collimating the sub-beams of electrodes, for scanning the sub-beams over the sample surface and being positioned at or near the intermediate focus of the sub-beams.

In an arrangement the macro scan deflector 236 is configured to deflect sub-beams so as to cause the sub-beams to be scanned relative to the surface of the sample 208, for example over the sample 208. The macro scan deflector 236 may be down-beam of the tube 70. Alternatively, the macro scan deflector 236 may be up-beam of the most down-beam end of the tube 70.

As shown in **FIG. 15****,** in an embodiment the macro scan deflector 236 comprises a magnetic component (which may also be referred to as a magnetic element, a magnetic part or a magnetic portion). The magnetic component of the macro scan deflector 236 is preferably outside of the tube 70. The tube 70 may be located radially inwardly of the macro scan deflector 236, for example relative to the path of the multi-beam, such as when viewed along the primary axis of the electron apparatus 40.

In an embodiment the most up-beam electrostatic component of the down-beam device 42 is at a different electric potential from the ending 72 of the tube 70 or down-beam section 70b. For example, in the arrangement shown in **FIG. 15****,** the electrostatic component that is immediately down-beam of the tube 70 may be the up-beam electrode 253 of the control lens array 250. The down-beam section 70b of the tube 70 may be configured to operate at a potential difference relative to the up-beam electrode 253 of the control lens array 250. By providing the potential difference, for example by way of the controller 50, an electric field between the most up-beam electrostatic component of the electron-optical device 41 and the ending 72 of the tube 70 is generated. The electric field is configured to collimate the sub-beams of electrons in the multi-beam. The electric field may function as a half lens 237 configured to act on the multi-beam of electrons, for example as a collimating electrostatic lens, i.e. by collimating the sub-beams.

As shown in **FIG. 15** and also described with reference to **FIG. 14****,** in an embodiment the array of condenser lenses 231 are configured to focus the sub-beams such that the intermediate foci of the sub-beams are located between the ending 72 of the tube 70 and the sample 208. The intermediate foci may be between the tube 70 and the control lens array 250. A plane of the intermediate foci may correspond to a gap between the ending of the tube 70 and the upper plate of the electrostatic device 41. The ending 72 of the down-beam section 70b of the tube 70 may be arranged such that the half lens 237 is configured to act on the sub-beams at or near the intermediate foci. The plane of the intermediate foci may correspond to the position of the magnetic macro scan deflector 236 along the paths of the sub-beam.

In the arrangement shown in **FIG. 14****,** the array of deflectors 235 may be configured to perform both scanning and collimating functions. In the arrangement shown in **FIG. 15****,** the macro scan deflector 236 may perform the scanning function. The half lens 237 formed by the electric field immediately down-beam of the tube 70 may perform the collimating function. In such an arrangement it may be unnecessary to provide the array of deflectors 235.

In an embodiment at least one of the electrodes of the array of condenser lenses 231 is at substantially the same potential as at least one of the sections 70a, 70b of the tube 70 between which the array of condenser lenses 231 is located. As described above, in an embodiment the array of condenser lenses 231 is formed of three plate arrays 231a, 231b, 231c in which electrons have the same energy as they enter and leave each lens, which arrangement may be referred to as an Einzel lens. In an embodiment the up-beam plate array 231a is at substantially the same potential as the up-beam section 70a of the tube 70. In a variation, there may be a small (e.g. no more than 100V) potential difference between the up-beam plate array 231a and the up-beam section 70a of the tube 70. In an embodiment the down-beam plate array 231c is at substantially the same potential as the down-beam section 70b of the tube 70. In a variation, there may be a small (e.g. no more than 100V) potential difference between the down-beam plate array 231c and the down-beam section 70b of the tube 70. An embodiment of the invention is expected to minimize any unwanted electric fields at the ending 72 of the up-beam section 70a adjacent the condenser lens array 231 and at the termination 71 of the down-beam section 70b of the tube 70. The ending 72 of the down-beam section 70b of the tube 70, for example with respect to down-beam device 42 down-beam of the ending of the down-beam section 70b, is controlled to provide an electric field adjacent to the ending 72 so as to form the half lens 237.

In an embodiment the electrostatic component of the electron-optical device 41 immediately down-beam of the tube 70 may have a similar (or the same) potential as the anode 122 and/or the up-beam section 70a of the tube 70. As explained above a potential difference may be controlled between the down-beam section 70b of the tube 70 and the electrostatic component of the electron-optical device 41 immediately down-beam of the tube 70. There may be a potential difference between the up-beam section 70a of the tube 70 and the down-beam section 70b of the tube 70. The potential difference may be at least 1kV, optionally at least 2kV and optionally at least 5kV. The potential difference may be at most 10kV and optionally at most 5kV. There may be a potential difference between the up-beam plate array 231a and the down-beam plate array 231c. The potential difference may be at least 1kV, optionally at least 2kV and optionally at least 5kV. The potential difference may be at most 10kV and optionally at most 5kV. Electrons may have a slightly different energy as they enter and leave each lens of the array of condenser lenses 231. The array of condenser lenses 231 functions substantially as an array of Einzel lenses.

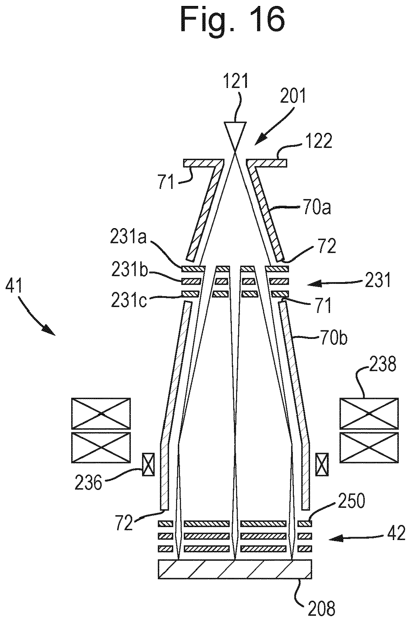

**FIG. 16** is a schematic diagram of an exemplary electron apparatus 40 according to an embodiment. The electron apparatus 40 is configured to project a multi-beam of electrons along a multi-beam path toward the sample 208. Features of the electron apparatus 40 that are described above with reference to **FIG. 14** directly and by reference to earlier embodiments and figures are not described again below, so as to avoid repetition. The features described below are, in general, different from the arrangement shown in **FIG. 14****.**

As shown in **FIG. 16****,** in an embodiment the electron apparatus 40 comprises a macro collimator 238. The macro collimator 238 may comprise a magnetic component. For example, the macro collimator 238 may comprise at least one pair of magnetic coils. The magnetic coils may be arranged such that the sub-beams of electrons maintain their angular orientation as the sub-beams of electrons are projected through the macro collimator 238. That is, the macro collimator may be a magnetic lens arrangement with a grid symmetrical angular rotation property (i.e. zero rotation or non-rotation property) for example relative to the grid of the beam arrangement. Thus the rotational position may be relative to the angle of rotational symmetry of the grid, for example 90 degrees for a square grid or 60 degrees for a hexagonal grid. The rotation of the beam arrangement (or at least net grid rotation relative to the angel of rotational symmetry) should be controlled such that the rotational position of the grid up-beam and down-beam of the macro collimator match. The macro collimator may effectively comprise two rotationally opposed magnetic lenses, or more than two rotationally cancelling magnetic lenses. The rotational effect of each magnetic lens on the path of the sub-beams counteracts each other so as to cancel substantially the rotational effect of the other lens out, for example relative to the net. Thus the lens arrangement, or at least part of the lens arrangement, has an anti-rotation property. The macro collimator 238 may be outside of the tube 70. The tube 70 may be located radially inwardly of the macro collimator 238. Although having the magnetic collimating lens within the tube is possible, such an arrangement would present engineering challenges. Note, although it is envisaged that the lens arrangement may apply zero-angular rotation to the beam arrangement, the lens arrangement may apply a residual angle, or grid symmetrical angle to the path of the beam arrangement. Thus the lens arrangement applies a residual angular displacement relative to the angle of rotational symmetry of the grid, i.e. of the beam arrangement.

As shown in **FIG. 16****,** in an embodiment the electron-optical device 41 comprises a macro scan deflector 236. The macro scan deflector 236 may be as described above with reference to **FIG. 15****.**

In the arrangement shown in **FIG. 14****,** the array of deflectors 235 may be configured to perform both scanning and collimating functions. In the arrangement shown in **FIG. 16****,** the macro scan deflector 236 may perform the scanning function. The macro collimator 238 may perform the collimating function. It may not be necessary to provide the array of deflectors 235. The down-beam section 70b of the tube 70 may extend between the condenser lens array 231 and the down-beam device 42. In such an arrangement there may be two sections of the tube 70: an up-beam section 70a and a down-beam section 70b.

As mentioned above, in some embodiments, one or more aberration correctors are provided that reduce one or more aberrations in the sub-beams for example generated by fields associated with an ending 72 or termination 71 of the tube 70 or a section 70a, 70b, 70c of the tube 70. In an embodiment the down-beam device 42 comprises one or more aberration correctors. Additionally or alternatively, one or more aberration correctors may be provided up-beam of the most down-beam end of the tube 70. For example, one or more aberration correctors may be associated with the condenser lens array 231 shown in **FIGS. 14-16****.** As another example, one or more aberration correctors may be associated with the deflector array shown in **FIGS. 13-14****.** Each aberration corrector may comprise an electrostatic component and/or a magnetic component. The electrostatic component may be down-beam of the tube 70 (e.g. comprised in the down-beam device 42) or inside the tube 70 or between adjoining sections of the tube 70. The magnetic component may be down-beam of the tube 70 (e.g. comprised in the down-beam device 42) or preferably outside the tube 70 or between adjoining sections of the tube 70.

The invention can be applied to various different tool architectures. For example, the electron apparatus 40 may comprise a plurality of electron-optical columns of multi-beams. The electron-optical columns may comprise the electron-optical device 41 described in any of the above embodiments or aspects. As a plurality of electron-optical columns (or a multi-column tool), the devices may be arranged in an array which may number two to one hundred electron-optical columns or more. The electron apparatus 40 may take the form of an embodiment as described with respect to and depicted in **FIG. 4** or as described with respect to and depicted in **FIG. 5****.** An electron-optical column may optionally comprise a source.

In an embodiment, the electron apparatus 40 comprises a plurality of electron-optical devices as depicted in the figures, for example at least **FIG. 3** and **FIG. 4****,** subject to the following comments, as a multi-column apparatus. Such a multi-column apparatus may comprise a plurality of electron-optical columns arranged in an array such as in a rectangular or hexagonal pattern. Each column of the multi-column apparatus may feature the features and functionality of the arrangement depicted in and disclosure in reference to **FIG. 3** herein. Alternatively, the multi-column apparatus may comprise a plurality of columns that are arranged in an array for example having a regular pattern and that comprise the features and functionality of the electron-optical device 41 depicted in and described with reference to **FIG. 4** subject to the following differences. Such differences include having an array of collimators, such as collimating deflectors for example integrated into the objective lens array assembly for example associated with, preferably immediately down beam of, an aperture of the sub-beam forming array 252. Each collimating deflector is assigned to a respective sub-beam of the multi-beam. The differences may comprise an array of scan deflectors integrated into the objective lens array assembly for example associated with the objective lens array 241. Having a scan deflector array and collimator array is beneficial because such devices are electrostatic instead of magnetic. Electron-optical column architectures having magnetic devices are difficult to integrate into a multi-column arrangement, although possible, because of the interference of the magnetic device with the surrounding columns of the multi-column arrangement.

In an embodiment there is provided a method for projecting a multi-beam of electrons toward a sample 208.

In an embodiment, the method comprises emitting an electron beam. In an embodiment, the method comprises projecting toward the sample 208 sub-beams of a multi-beam of electrons derived from the electron beam using an electron-optical device 41. The multi-beam of electrons may be for detecting defects of the sample 208.

In an embodiment, the method comprises accelerating the electron beam toward the sample 208 using a tube 70 surrounding the multi-beam path. The tube operates at the first potential difference from ground.

In an embodiment, the method comprises holding the sample 208 at a second potential difference from ground. The first potential difference is greater than the second potential difference. The second potential difference may be substantially zero.

Reference to a component or system of components or elements being controllable to manipulate an electron beam in a certain manner includes configuring a controller or control system or control unit to control the component to manipulate the electron beam in the manner described, as well optionally using other controllers or devices (e.g. voltage supplies and or current supplies) to control the component to manipulate the electron beam in this manner. For example, a voltage supply may be electrically connected to one or more components to apply potentials to the components, such as in a non-limited list the control lens array 250, the objective lens array 241, the condenser lenses 231, correctors, a collimator element array and deflector arrays 235, 265, under the control of the controller or control system or control unit. An actuatable component, such as a stage, may be controllable to actuate and thus move relative to another components such as the beam path using one or more controllers, control systems, or control units to control the actuation of the component.

The embodiments herein described may take the form of a series of aperture arrays or electron-optical elements arranged in arrays along a beam or a multi-beam path. Such electron-optical elements may be electrostatic. In an embodiment all the electron-optical elements, for example from a sub-beam forming array to a last electron-optical element in a sub-beam path before a sample, may be electrostatic and/or may be in the form of an aperture array or a plate array.

In some arrangements one or more of the electron-optical elements are manufactured as a microelectromechanical system (MEMS) (i.e. using MEMS manufacturing techniques). MEMS are miniaturized mechanical and electromechanical elements that are made using microfabrication techniques. For example, in an embodiment, the exchangeable module is a MEMS module.

In an embodiment, the exchangeable module is configured to be replaceable within the electron apparatus 40. In an embodiment, the exchangeable module is configured to be field replaceable. Field replaceable is intended to mean that the module may be removed and replaced with the same or different module while maintaining the vacuum in which the electron-optical tool 40 is located. Only a section of the electron apparatus 40 is vented corresponding to the module is vented for the module to be removed and returned or replaced. The control lens array 250 may be in the same module as an objective lens array 241, i.e. forming an objective lens array assembly or objective lens arrangement, or it may be in a separate module.

References to upper and lower, up and down, above and below should be understood as referring to directions parallel to the (typically but not always vertical) up-beam and down-beam directions of the beam or multi-beam of electrons impinging on the sample 208. Thus, references to up beam and down beam are intended to refer to directions in respect of the beam path independently of any present gravitational field.

An electron apparatus according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical column may be a component of an assessment system; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector.

References to elements being aligned along a beam path or sub-beam path are understood to mean that the respective elements are positioned along the beam path or sub-beam path.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

Clause 1: A charged particle apparatus configured to project a multi-beam of charged particles along a multi-beam path toward a sample, the charged particle apparatus comprising: a charged particle source configured to emit a charged particle beam toward a sample; a charged particle-optical device configured to project sub-beams of a multi-beam of charged particles along the multi-beam path toward the sample, the sub-beams of the multi-beam of charged particles derived from the charged particle beam; a tube surrounding the multi-beam path configured to operate at a first potential difference from a ground potential; and a support configured to support the sample at a second potential difference from the ground potential, the first potential difference and the second potential difference having a difference so as to accelerate the multi-beam of charged particles towards the sample; wherein the first potential difference is greater than the second potential difference.

Clause 2: The charged particle apparatus of any preceding claim, wherein the tube comprises at least one section, each section extending along different positions along the multi-beam path and surrounding the multi-beam path.

Clause 3: The charged particle apparatus of claim 2, wherein at least part of the charged particle-optical device is down-beam of a most down-beam end of the tube, the charged particle-optical device that is down-beam of the most down-beam end of the tube being a down-beam device.

Clause 4: The charged particle apparatus of claim 3, wherein the potential difference between the most down-beam end of the tube and a most up-beam electrostatic component of the down-beam device is less than the first potential difference.

Clause 5: The charged particle apparatus of claim 4, wherein the most up-beam electrostatic component of the down-beam device is at the same electric potential as the most down-beam end of the tube.

Clause 6: The charged particle apparatus of claim 4, wherein the most up-beam electrostatic component of the down-beam device is at a different electric potential from the most down-beam end of the tube such that an electric field between the most up-beam electrostatic component of the down-beam device and the down-beam end of the tube collimates respective sub-beams of the multi-beam of charged particles.

Clause 7: The charged particle apparatus of any of claims 3 to 6, wherein the down-beam device comprises an up-beam plate (i.e. being the most up-beam electrostatic component of the device) in which is defined an array of apertures for the paths of the sub-beams of the multi-beam of charged particles.

Clause 8: The charged particle apparatus of claim 7, wherein the down-beam device comprises a plurality of plates in each of which are defined an array of apertures for the paths of the sub-beams of the multi-beam of charged particles, the plurality of plates comprising the up-beam plate.

Clause 9: The charged particle apparatus of claim 8, wherein the up-beam plate is a sub-beam forming array, the apertures configured to form the sub-beams of the multi-beam of charged particles from the charged particle beam from the charged particle source.

Clause 10: The charged particle apparatus of claim 9, wherein the plurality of plates comprises a beam shaping aperture array in which is defined an array of beam shaping apertures for shaping the sub-beams of the multi-beam of charged particles, the beam shaping aperture array being down-beam of the up-beam plate.

Clause 11: The charged particle apparatus of any of claims 3 to 10, wherein the down-beam device comprises an objective lens array comprising a plurality of objective lenses configured to focus respective sub-beams of the multi-beam of charged particles on the sample.

Clause 12: The charged particle apparatus of any of claims 3 to 11, wherein the down-beam device comprises a detector.

Clause 13: The charged particle apparatus of claim 12, wherein the detector comprises a detector array comprised in one or more of the plates of the down-beam device.

Clause 14: The charged particle apparatus of claim 13, wherein the detector array comprises a detector element associated with a respective sub-beam of the multi-beam of charged particles.

Clause 15: The charged particle apparatus of claim 13 or 14, wherein at least part of the detector array is proximate the sample.

Clause 16: The charged particle apparatus of any of claims 12 to 15, wherein at least part of the detector array is comprised in a most down-beam plate of the down-beam device.

Clause 17: The charged particle apparatus of any of claims 12 to 16, wherein at least part of the detector array faces the sample.

Clause 18: The charged particle apparatus of any of claims 2 to 15, wherein the charged particle-optical device comprises a scan deflector configured to deflect respective portions of the charged particle beam to cause the sub-beams of the multi-beam of charged particles to be scanned over the sample.

Clause 19: The charged particle apparatus of claim 18, wherein the scan deflector comprises a macro scan deflector.

Clause 20: The charged particle apparatus of claim 19, wherein the macro scan deflector comprises a magnetic deflector.

Clause 21: The charged particle apparatus of claim 20, wherein the magnetic deflector is outside of the tube.

Clause 22: The charged particle apparatus of any of claims 18 to 21, wherein the scan deflector comprises an electrostatic deflector.

Clause 23: The charged particle apparatus of any of claims 18 to 22, wherein the scan deflector comprises an array of deflectors configured to deflect respective sub-beams of the multi-beam of charged particles to cause the sub-beams to be scanned over the sample.

Clause 24: The charged particle apparatus of claim 23, wherein the deflectors are further configured to collimate respective sub-beams of the multi-beam of charged particles.

Clause 25: The charged particle apparatus of any of claims 18 to 24, wherein at least part of the scan deflector is inside the tube.

Clause 26: The charged particle apparatus of any of claims 18 to 25, wherein at least part of the scan deflector is between adjacent sections of the tube.

Clause 27: The charged particle apparatus of any of claims 2 to 26, wherein the charged particle-optical device comprises at least one electrostatic component located between adjacent sections of the tube.

Clause 28: The charged particle apparatus of claim 27, wherein the electrostatic component is at substantially the same electric potential as at least one of the sections of the tube between which the electrostatic component is located.

Clause 29: The charged particle apparatus of claim 28, wherein the electrostatic component comprises a plurality of plates along the path of the multi-beam, in each plate are defined an array of apertures for the paths of the sub-beams of the multi-beam of charged particles, at least one of an up-beam plate and a down-beam plate being at the same electric potential as its adjoining section of the tube.

Clause 30: The charged particle apparatus of claim 29, wherein the up-beam plate is a sub-beam forming array, the apertures configured to form the sub-beams of the multi-beam of charged particles from the charged particle beam from the charged particle source.

Clause 31: The charged particle apparatus of any of claims 27 to 30, wherein the at least one electrostatic component located between adjacent sections of the tube comprises an array of condenser lenses configured to direct charged particles of respective sub-beams of the multi-beam of charged particles to respective intermediate foci.

Clause 32: The charged particle apparatus of claim 31, further comprising a collimator configured to collimate the sub-beams.

Clause 33: The charged particle apparatus of claim 32, wherein the collimator is located at or around a plane of the intermediate foci.

Clause 34: The charged particle apparatus of claim 32 or 33, wherein the at least one electrostatic component being located between adjacent sections of the tube comprises at least part of the collimator.

Clause 35: The charged particle apparatus of any of claims 32 to 34, wherein the collimator comprises a macro collimator configured to collimate respective sub-beams of the multi-beam of charged particles.

Clause 36: The charged particle apparatus of claim 35, wherein the macro collimator comprises a magnetic component.

Clause 37: The charged particle apparatus of claim 35 or 36, wherein the macro collimator is located outside of the tube.

Clause 38: The charged particle apparatus of any of claims 35 to 37, wherein the macro collimator comprises an electrostatic component.

Clause 39: The charged particle apparatus of any of claims 35 to 38, wherein the macro collimator is located at or near an intermediate focal plane comprising the intermediate foci.

Clause 40: The charged particle apparatus of any preceding claim, wherein a potential difference between a most down-beam component of the charged particle-optical device and the ground potential is less than the first potential difference.

Clause 41: The charged particle apparatus of claim 40, wherein the most down-beam component has a potential proximate to the second potential difference.

Clause 42: The charged particle apparatus of any preceding claim, wherein the charged particle source comprises a cathode and an anode configured to operate with a potential difference between the cathode and the anode so as to emit the charged particle beam, wherein the tube is at the same electric potential as the anode.

Clause 43: The charged particle apparatus of claim 42, wherein the tube is electrically connected to the anode.

Clause 44: The charged particle apparatus of any preceding claim, wherein the second potential difference is substantially zero.

Clause 45: The charged particle apparatus of any preceding claim, wherein the sample is at the ground potential.

Clause 46: A method for projecting a multi-beam of charged particles toward a sample, the method comprising: emitting a charged particle beam; projecting along a multi-beam path toward a sample sub-beams of a multi-beam of charged particles derived from the charged particle beam using a charged particle-optical device; accelerating the charged particle beam toward the sample using a tube surrounding the multi-beam path, wherein the tube operates at a first potential difference from a ground potential; and holding the sample at a second potential difference from the ground potential; wherein the first potential difference is greater than the second potential difference.

The descriptions above are intended to be illustrative, not limiting. Thus, it will be apparent to one skilled in the art that modifications may be made as described without departing from the scope of the claims set out below.

## Claims

1. A charged particle apparatus configured to project a multi-beam of charged particles along a multi-beam path toward a sample, the charged particle apparatus comprising:
a charged particle source configured to emit a charged particle beam toward a sample;
a charged particle-optical device configured to project sub-beams of a multi-beam of charged particles along the multi-beam path toward the sample, the sub-beams of the multi-beam of charged particles derived from the charged particle beam;
a tube surrounding the multi-beam path configured to operate at a first potential difference from a ground potential; and
a support configured to support the sample at a second potential difference from the ground potential, the first potential difference and the second potential difference having a difference so as to accelerate the multi-beam of charged particles towards the sample;
wherein the first potential difference is greater than the second potential difference.

2. The charged particle apparatus of any preceding claim, wherein the tube comprises at least one section, each section extending along different positions along the multi-beam path and surrounding the multi-beam path.

3. The charged particle apparatus of claim 2, wherein at least part of the charged particle-optical device is down-beam of a most down-beam end of the tube, the charged particle-optical device that is down-beam of the most down-beam end of the tube being a down-beam device.

4. The charged particle apparatus of claim 3, wherein the potential difference between the most down-beam end of the tube and a most up-beam electrostatic component of the down-beam device is less than the first potential difference.

5. The charged particle apparatus of claim 4, wherein the most up-beam electrostatic component of the down-beam device is at the same electric potential as the most down-beam end of the tube.

6. The charged particle apparatus of any of claims 5, wherein the down-beam device comprises an up-beam plate (i.e. being the most up-beam electrostatic component of the device) in which is defined an array of apertures for the paths of the sub-beams of the multi-beam of charged particles.

7. The charged particle apparatus of claim 6, wherein the down-beam device comprises a plurality of plates in each of which are defined an array of apertures for the paths of the sub-beams of the multi-beam of charged particles, the plurality of plates comprising the up-beam plate.

8. The charged particle apparatus of claim 7, wherein the up-beam plate is a sub-beam forming array, the apertures configured to form the sub-beams of the multi-beam of charged particles from the charged particle beam from the charged particle source.

9. The charged particle apparatus of claim 8, wherein the plurality of plates comprises a beam shaping aperture array in which is defined an array of beam shaping apertures for shaping the sub-beams of the multi-beam of charged particles, the beam shaping aperture array being down-beam of the up-beam plate.

10. The charged particle apparatus of any of claims 3 to 9, wherein the down-beam device comprises an objective lens array comprising a plurality of objective lenses configured to focus respective sub-beams of the multi-beam of charged particles on the sample.

11. The charged particle apparatus of any of claims 3 to 10, wherein the down-beam device comprises a detector and at least part of the detector array is comprised in a most down-beam plate of the down-beam device.

12. The charged particle apparatus of any of claims 2 to 11, wherein the charged particle-optical device comprises a scan deflector configured to deflect respective portions of the charged particle beam to cause the sub-beams of the multi-beam of charged particles to be scanned over the sample.

13. The charged particle apparatus of any of claims 2 to 12, wherein the charged particle-optical device comprises at least one electrostatic component located between adjacent sections of the tube.

14. The charged particle apparatus of any preceding claim, wherein a potential difference between a most down-beam component of the charged particle-optical device and the ground potential is less than the first potential difference.

15. The charged particle apparatus of any preceding claim, wherein the charged particle source comprises a cathode and an anode configured to operate with a potential difference between the cathode and the anode so as to emit the charged particle beam, wherein the tube is at the same electric potential as the anode and the sample is at the ground potential.
